# EUROPEAN PATENT APPLICATION

(11) **EP 4 773 441 A1**
(43) Date of publication of application: **08.07.2026**
(21) Application number: 24860275.7
(22) Date of filing: 16.08.2024
(51) Int. Cl.: H01Q 21/24, H01Q 1/02, H01Q 21/06, H01Q 19/10, H01Q 3/26, H05K 7/20

(54) **HEAT DISSIPATION MODULE, HEAT DISSIPATION DEVICE INCLUDING SAME, RF MODULE FOR ANTENNA, ANTENNA DEVICE, AND LIGHTING DEVICE**

(30) Priority: 28.08.2023 KR 20230112779; 14.09.2023 KR 20230122177; 06.12.2023 KR 20230175246; 13.08.2024 KR 20240107995
(71) Applicant: KMW Inc., Hwaseong-si, Gyeonggi-do 18462 (KR)
(72) Inventor: KIM, Duk Yong, Yongin-si Gyeonggi-do 17086 (KR); JEONG, Bae Mook, Suwon-si Gyeonggi-do 16545 (KR); YUN, Min Seon, Anyang-si Gyeonggi-do 13967 (KR); CHOI, Oh Seog, Hwaseong-si Gyeonggi-do 18430 (KR); PARK, Min Sik, Hwaseong-si Gyeonggi-do 18376 (KR); RYU, Chi Back, Hwaseong-si Gyeonggi-do 18378 (KR); SEO, Yong Won, Hwaseong-si Gyeonggi-do 18442 (KR); KIM, Hye Yeon, Hwaseong-si Gyeonggi-do 18496 (KR); CHOI, In Hwa, Yongin-si Gyeonggi-do 17148 (KR)
(74) Representative: impuls legal PartG mbB
(86) International application number: PCT/KR2024/012192
(87) International publication number: WO 2025/048354

(57) **Abstract**

The present invention relates to a heat dissipation module, a heat dissipation device including same, an antenna device, and a lighting device. The heat dissipation module comprises a heat conduction panel body having a refrigerant flow space that is a sealed space in which a refrigerant is accommodated and circulates between liquid and vapor phases while undergoing a phase change to transfer heat, wherein the refrigerant flow space comprises: a first section serving as an evaporation region that receives heat from a heat-generating element to be cooled; and a second section serving as a path through which a liquid refrigerant, condensed from a vapor phase of the refrigerant, flows to the first section by surface tension or gravity, and wherein the heat-generating element is coupled to an outer side of the heat conduction panel body corresponding to the first section by either a fitting method or a bonding method.

## Description

### [Technical Field]

The present disclosure relates to a heat dissipation module and a heat dissipation device, an RF module for an antenna, an antenna device, and a lighting device including the same, and more particularly, to a heat dissipation module, and a heat dissipation device, an RF module for an antenna, an antenna device, and a lighting device including the same, which are capable of rapidly discharging system operating heat to the outside from an installation space when a distributed arrangement design of heat-generating elements within a limited installation space due to electrical operation is required, thereby further improving the performance of the device.

### [Background Art]

In general, an electronic apparatus (electronic device) is an apparatus or device that operates using electrical energy.

Such an electronic apparatus (electronic device) includes functional elements that operate using supplied electrical energy as main system operating components and generate a predetermined amount of operating heat.

However, it is well known that the main performance of the electronic apparatus (electronic device) depends on discharging, as quickly and effectively as possible, the operating heat generated from the above-described functional elements; however, recent electronic apparatuses (electronic devices) tend to be designed to be smaller and more compact. Further, because the portion in which heat dissipation mainly occurs varies depending on the inherent function of each electronic apparatus (electronic device), the apparatus is inevitably designed to provide concentrated heat dissipation using a part of the electronic apparatus (electronic device). As a result, design flexibility of the product is significantly limited.

Representative electronic apparatuses (electronic devices) having such functional elements and configurations requiring heat dissipation include a wireless communication device (e.g., antenna device) manufactured by the applicant of the present disclosure.

In particular, in an antenna device, which is one of the representative electronic apparatuses (electronic devices), beam forming is a signal processing technique that concentrates a directional signal on a specific location or receiver. In general, an array antenna in which a plurality of radiating elements are arranged is used to implement a sharp beam pattern using the plurality of radiating elements. Here, in order to make the beam narrower, the antenna elements are arranged in the form of sub-arrays, and an RF chain is provided for each sub-array.

Meanwhile, if low Earth orbit (LEO) satellite communication services for drones or urban air mobility (UAM) become active in the future, a living zone at a service altitude range of approximately 200 to 300 meters above the ground will be formed, and in response thereto, antennas also need to cover regions higher than their installation positions.

However, when the antenna elements are provided as the sub-arrays, the tilting range (or steering range) of a vertical beam is very limited to about ±10 degrees (based on 64 TRx), and forced tilting results in sidelobes and scan loss.

In order to address these issues, there is a growing trend toward a digital control method in which each individual antenna unit is controlled in a digital domain. In this case, however, the amount of heat generated by individual functional elements (e.g., heat-generating elements) further increases, making heat dissipation issues more urgent to prevent performance degradation of the functional elements.

This is also one of the major issues in a lighting device, which directly performs the primary function of converting electrical energy into light energy.

### [Disclosure]

### [Technical Problem]

The present disclosure is proposed to resolve the aforementioned technical issues and is directed to providing a heat dissipation module, and a heat dissipation device, an RF module for an antenna, an antenna device, and a lighting device including the same, which can offer diversity in layout design of internal main functional elements of an electronic apparatus (electronic device).

In addition, the present disclosure is also directed to providing a heat dissipation module, and a heat dissipation device, an RF module for an antenna, an antenna device, and a lighting device including the same, which can rapidly and efficiently dissipate system operating heat generated from functional elements disposed within a closed installation space to the outside, thereby preventing performance degradation of the functional elements.

Further, the present disclosure is directed to providing an RF module for an antenna and an antenna device including the same, which, when an electronic apparatus is implemented as an antenna device, can expand a tilting range of a vertical beam by matching an RF chain to each signal of respective radiating elements and individually controlling the signals of the respective radiating elements at a digital domain, and can implement Massive MIMO for 5G-Advanced to 6G next-generation communication by improving and applying a heat dissipation structure that efficiently dissipates heat generated from a heat-generating surface of an antenna unit.

Technical issues of the present disclosure are not limited to the technical issues mentioned above, and other technical issues not mentioned above will be clearly understood by those skilled in the art from the following description.

### [Technical Solution]

A heat dissipation module according to one embodiment of the present disclosure includes: a heat conduction panel body having a refrigerant flow space that is a sealed space in which a refrigerant is accommodated and circulates between liquid and vapor phases while undergoing a phase change to transfer heat, the refrigerant flow space includes a first section serving as an evaporation region that receives heat from a heat-generating element to be cooled, and a second section serving as a path through which a liquid refrigerant, condensed from a vapor phase of the refrigerant, flows to the first section by surface tension or gravity, and the heat-generating element is coupled to an outer side of the heat conduction panel body corresponding to the first section by either a fitting method or a bonding method.

The first section of the refrigerant flow space may be disposed within an inner space in which the heat-generating elements are arranged, and at least a portion of the second section of the refrigerant flow space may be disposed so as to be exposed to an outer space physically partitioned from the inner space.

When the inner space and the outer space are physically partitioned by a housing body, the first section of the refrigerant flow space may be positioned relatively lower with respect to a direction of gravity and be disposed in an internal space of the housing body, and the second section of the refrigerant flow space may be positioned relatively higher with respect to the direction of gravity and be disposed so as to be exposed to the outer space outside the housing body.

The refrigerant flow space may be formed such that the first section and the second section communicate with each other so that, as the refrigerant undergoes the phase change, the refrigerant circulates between vapor and liquid phases and flows from a lower end of the first section to an upper end of the second section.

when a portion of the heat conduction panel body corresponding to the first section is defined as an inner heat dissipation portion, the inner heat dissipation portion may be provided as either a heat pipe or a first phase-change fin, in which a refrigerant is accommodated therein and the accommodated refrigerant undergoes a phase change to circulate between vapor and liquid phases.

The first phase-change fin may have one surface made of SUS and the other surface made of Cu.

when a portion of the heat conduction panel body corresponding to the second section is defined as an outer heat dissipation portion, the outer heat dissipation portion may be configured as a second phase-change fin that communicates with the first section and in which the refrigerant, phase-changed into a vapor phase refrigerant from the first section, is heat-exchanged with outside air and condensed into a liquid phase refrigerant.

The second phase-change fin may have one surface made of SUS and the other surface made of Cu.

A heat dissipation device according to one embodiment of the present disclosure includes: a functional element that is electrically driven and performs a predetermined function, a plurality of device modules configured to control the functional element on a module-by-module basis, and a heat dissipation module coupled to the device modules in a vertical or horizontal direction so as to dissipate heat generated from heat-generating surfaces of heat-generating elements provided in the device modules for respective functions, and the heat dissipation module may include a heat conduction panel body having a refrigerant flow space that is a sealed space in which a refrigerant is accommodated and circulates between liquid and vapor phases while undergoing a phase change to transfer heat, and the refrigerant flow space may include a first section serving as an evaporation region that receives heat from a heat-generating element to be cooled, and a second section serving as a path through which a liquid refrigerant, condensed from a vapor phase of the refrigerant, flows to the first section by surface tension or gravity, and the heat-generating element may be coupled to an outer side of the heat conduction panel body corresponding to the first section by either a fitting method or a bonding method.

The first section of the refrigerant flow space may be disposed within an inner space in which the heat-generating elements are arranged, and at least a portion of the second section of the refrigerant flow space may be exposed to an outer space that is physically partitioned from the inner space.

When the inner space and the outer space are physically partitioned by a housing body, the first section of the refrigerant flow space may be positioned relatively lower with respect to a direction of gravity and be disposed in an internal space of the housing body, and the second section of the refrigerant flow space may be positioned relatively higher with respect to the direction of gravity and be disposed so as to be exposed to the outer space outside the housing body.

The refrigerant flow space may be formed such that the first section and the second section communicate with each other so that, as the refrigerant undergoes the phase change, the refrigerant circulates between vapor and liquid phases and flows from a lower end of the first section to an upper end of the second section.

when a portion of the heat conduction panel body corresponding to the first section is defined as an inner heat dissipation portion, the inner heat dissipation portion may be provided as either a heat pipe or a first phase-change fin, in which a refrigerant is accommodated therein and the accommodated refrigerant undergoes a phase change to circulate between vapor and liquid phases.

The first phase-change fin may have one surface made of SUS and the other surface made of Cu.

when a portion of the heat conduction panel body corresponding to the second section is defined as an outer heat dissipation portion, the outer heat dissipation portion may be configured as a second phase-change fin that communicates with the first section and in which the refrigerant, phase-changed into a vapor phase refrigerant from the first section, is heat-exchanged with outside air and condensed into a liquid phase refrigerant.

The second phase-change fin may have one surface made of SUS and the other surface made of Cu.

An RF module for an antenna according to one embodiment of the present disclosure includes: a radiating element having at least one polarization, a plurality of antenna units each including an RF chain corresponding to each polarization of the radiating element so as to individually control the polarization of the radiating element, and a heat dissipation module coupled to the antenna units in a vertical or horizontal direction so as to dissipate heat generated from heat-generating surfaces of heat-generating elements provided in polarization-specific antenna units among the plurality of adjacent antenna units, and the heat dissipation module includes a heat conduction panel body having a refrigerant flow space that is a sealed space in which a refrigerant is accommodated and circulates between liquid and vapor phases while undergoing a phase change to transfer heat, and the refrigerant flow space includes a first section serving as an evaporation region that receives heat from the heat-generating element to be cooled, and a second section serving as a path through which a liquid refrigerant, condensed from a vapor phase of the refrigerant, flows to the first section by surface tension or gravity, and the heat-generating element is coupled to an outer side of the heat conduction panel body corresponding to the first section by either a fitting method or a bonding method.

An RF module for an antenna according to another embodiment of the present disclosure includes: a radiating element having a plurality of polarizations, a plurality of antenna units stacked with one another, each antenna unit including an RF chain corresponding to each polarization of the radiating element, and a heat dissipation module configured to dissipate heat generated from a plurality of heat-generating elements that are vertically arranged such that heat-generating surfaces thereof face left and right, respectively, on one side of a plurality of RF filters involved in one polarization among the plurality of adjacent antenna units, and the heat dissipation module includes a heat conduction panel body having a refrigerant flow space that is a sealed space in which a refrigerant is accommodated and circulates between liquid and vapor phases while undergoing a phase change to transfer heat, and the refrigerant flow space includes a first section serving as an evaporation region that receives heat from the heat-generating element to be cooled, and a second section serving as a path through which a liquid refrigerant, condensed from a vapor phase of the refrigerant, flows to the first section by surface tension or gravity, and the heat-generating element is coupled to an outer side of the heat conduction panel body corresponding to the first section by either a fitting method or a bonding method.

Each of the plurality of antenna units may include a first polarization antenna unit involved in one polarization of the radiating element that is configured to radiate a dual-polarized beam, and a second polarization antenna unit involved in the other polarization of the radiating element that is configured to radiate the dual-polarized beam.

The first polarization antenna unit may include a plurality of one-side RF filters arranged in a stack-up configuration in a single row in an up-down direction and stacked in a tile-type structure vertically such that opposite ends in a longitudinal direction are positioned at front and rear, respectively, and the second polarization antenna unit may include a plurality of other-side RF filters arranged in a stack-up configuration in a single row in the up-down direction to be stacked in a left-right direction with respect to one of left and right sides of the plurality of one-side RF filters and stacked in a tile-type structure vertically such that opposite ends in a longitudinal direction are positioned at front and rear, respectively, and filters stacked in the tile-type structure at the same vertical position among the plurality of one-side RF filters and the plurality of other-side RF filters may constitute two RF channels.

Each of the plurality of antenna units may further include a one-side feeder line and an other-side feeder line configured to feed predetermined electrical signals to the plurality of one-side RF filters and the plurality of other-side RF filters that constitute the two RF channels, and a PA board on which heat-generating elements involved in any one of the two RF channels are mounted on one of opposite surfaces thereof, and the PA board may be stacked and disposed in the tile-type structure on any one of left and right sides of the plurality of one-side RF filters and the plurality of other-side RF filters.

The plurality of heat-generating elements mounted on the PA board may include at least one of a Power Amplifier (PA), a Low Noise Amplifier (LNA), and an RFIC.

The heat dissipation module may be stacked and disposed in surface thermal contact with an outer surface of the PA board of each of the first polarization antenna unit and the second polarization antenna unit, and may receive and dissipate heat generated from the plurality of heat-generating elements.

The heat dissipation module may include an inner heat dissipation portion in surface thermal contact with one side of the PA board on which the plurality of heat-generating elements are mounted, and an outer heat dissipation portion configured to dissipate heat transferred from the inner heat dissipation portion through heat exchange with outside air.

The inner heat dissipation portion and the outer heat dissipation portion may be formed to communicate with each other such that a refrigerant is accommodated therein and the accommodated refrigerant circulates between vapor and liquid phases.

The inner heat dissipation portion may be provided as either a plurality of heat pipes or a first phase-change fin of a panel-type heat exchanger, in which a refrigerant is accommodated therein and the accommodated refrigerant undergoes a phase change to circulate between vapor and liquid phases.

The inner heat dissipation portion and the outer heat dissipation portion may be provided as a second phase-change fin of a panel-type heat exchanger, which is formed so that a refrigerant is accommodated therein and the inner and outer heat dissipation portions communicate with each other to allow the accommodated refrigerant to circulate between vapor and liquid phases from the inner heat dissipation portion to the outer heat dissipation portion.

The inner heat dissipation portion provided as the first phase-change fin of the panel-type heat exchanger may have one surface made of Cu, the one surface being in surface thermal contact with one side of the PA board, and the other surface made of SUS, the other surface not being in surface thermal contact with the one side of the PA board.

The outer heat dissipation portion and the inner heat dissipation portion, each provided as the second phase-change fin of the panel-type heat exchanger, may have opposite surfaces made of SUS.

The outer heat dissipation portion provided as the second phase-change fin of the panel-type heat exchanger may have opposite surfaces made of SUS, and the inner heat dissipation portion provided as the second phase-change fin of the panel-type heat exchanger may have one surface made of Cu, the one surface being in surface thermal contact with one side of the PA board, and the other surface made of SUS, the other surface not being in surface thermal contact with the one side of the PA board.

The inner heat dissipation portion and the outer heat dissipation portion may be manufactured such that a refrigerant flow space, in which the refrigerant is accommodated, is formed by joining edges of two metal panel members manufactured by a press forming process, and the two metal panel members may be provided with a plurality of strength reinforcement portions formed by the press forming process to reinforce rigidity thereof and to be mutually joined at least within the refrigerant flow space.

When the two metal panel members are made of Cu or SUS, the refrigerant may be water.

The radiating element may include a first polarization element connected to a signal transmitted along the one-side feeder line and arranged to be connected to the plurality of one-side RF filters, and a second polarization element connected to a signal transmitted along the other-side feeder line and arranged to be connected to the plurality of other-side RF filters, and the first polarization element and the second polarization element may be seated on front ends of the plurality of one-side RF filters and the plurality of other-side RF filters while one end and the other end thereof cross each other.

Front end surfaces of the plurality of one-side RF filters and the plurality of other-side RF filters may perform a function of a reflector that reflects a beam radiated from the radiating element forward.

The radiating element may further include a base panel disposed to partition between the plurality of one-side RF filters and the plurality of other-side RF filters and the first polarization element and the second polarization element, the base panel supporting the first polarization element and the second polarization element, and the base panel may have a forward protruding height configured to block radiation of a radiated beam from the first polarization element and the second polarization element toward an adjacent radiating element.

The base panel may be supported forward by the PA board.

An RF module for an antenna according to another embodiment of the present disclosure includes a radiating element having dual polarization, a first polarization antenna unit and a second polarization antenna unit each including an RF chain corresponding to each polarization of the radiating element so as to individually control the dual polarizations of the radiating element, and a heat dissipation module configured to dissipate heat generated from heat-generating surfaces of respective heat-generating elements provided in the first polarization antenna unit and the second polarization antenna unit, and the heat dissipation module is a panel-type heat exchanger, and heat-generating elements of the first polarization antenna unit and the second polarization antenna unit are disposed in surface thermal contact with one side and the other side thereof, respectively.

The first polarization antenna unit may include a plurality of one-side RF filters arranged in a stack-up configuration in a single row in an up-down direction and stacked in a tile-type structure vertically such that opposite ends in a longitudinal direction are positioned at front and rear, respectively, the second polarization antenna unit may include a plurality of other-side RF filters arranged in a stack-up configuration in a single row in the up-down direction to be stacked in a left-right direction with respect to one of left and right sides of the plurality of one-side RF filters and stacked in a tile-type structure vertically such that opposite ends in a longitudinal direction are positioned at front and rear, respectively, and filters stacked in the tile-type structure at the same vertical position among the plurality of one-side RF filters and the plurality of other-side RF filters may constitute two RF channels.

Each of the plurality of antenna units may further include a one-side feeder line and an other-side feeder line configured to feed predetermined electrical signals to the plurality of one-side RF filters and the plurality of other-side RF filters that constitute the two RF channels, and a PA board on which heat-generating elements involved in any one of the two RF channels are mounted on one of opposite surfaces thereof, and the PA board may be stacked and disposed in the tile-type structure on any one of left and right sides of the plurality of one-side RF filters and the plurality of other-side RF filters.

The single heat dissipation module may include an inner heat dissipation portion in surface thermal contact with one side of the PA board on which the plurality of heat-generating elements are mounted, and an outer heat dissipation portion configured to dissipate heat transferred from the inner heat dissipation portion through heat exchange with outside air.

The one-side RF filter and the other-side RF filter may be formed such that a front-rear width thereof is greater than a front-rear width of the inner heat dissipation portion of the heat dissipation module, and the first polarization antenna unit and the second polarization antenna unit may be coupled to one side and the other side of the single heat dissipation module, respectively, with the PA board involved in the two RF channels interposed therebetween, by fixing screws fastened through front coupling flanges and rear coupling flanges formed at front ends and rear ends of the one-side RF filter and the other-side RF filter.

An antenna device according to one embodiment of the present disclosure includes an antenna housing body having a box shape with a front surface open and an installation space formed therein, a digital board stacked and coupled within the installation space such that a rear surface thereof is in close contact therewith, and having heat-generating elements mounted and disposed on at least one of opposite surfaces thereof, and an RF module for an antenna electrically signal-connected to the digital board, the RF module being vertically disposed in an up-down direction such that opposite surfaces thereof face left and right within the installation space, and the RF module for the antenna includes a radiating element having at least one polarization, a plurality of antenna units each including an RF chain corresponding to each polarization of the radiating element so as to individually control the polarization of the radiating element, and a heat dissipation module coupled to the antenna units in a vertical or horizontal direction so as to dissipate heat generated from heat-generating surfaces of heat-generating elements provided in polarization-specific antenna units among the plurality of adjacent antenna units, and the heat dissipation module includes an inner heat dissipation portion extending into the installation space to receive and conduct heat from the heat-generating elements, and an outer heat dissipation portion extending to an outside of the installation space to exchange heat transferred from the inner heat dissipation portion with air (outside air) in an outer space.

Each of the plurality of antenna units may include a first polarization antenna unit involved in one polarization of the radiating element that is configured to radiate a dual-polarized beam, and a second polarization antenna unit involved in the other polarization of the radiating element that is configured to radiate the dual-polarized beam.

The first polarization antenna unit may include a plurality of one-side RF filters arranged in a stack-up configuration in a single row in an up-down direction and stacked in a tile-type structure vertically such that opposite ends in a longitudinal direction are positioned at front and rear, respectively, the second polarization antenna unit may include a plurality of other-side RF filters arranged in a stack-up configuration in a single row in the up-down direction to be stacked in a left-right direction with respect to one of left and right sides of the plurality of one-side RF filters and stacked in a tile-type structure vertically such that opposite ends in a longitudinal direction are positioned at front and rear, respectively, and filters stacked in the tile-type structure at the same vertical position among the plurality of one-side RF filters and the plurality of other-side RF filters may constitute two RF channels.

Each of the plurality of antenna units may further include a one-side feeder line and an other-side feeder line configured to feed predetermined electrical signals to the plurality of one-side RF filters and the plurality of other-side RF filters that constitute the two RF channels, and a PA board on which heat-generating elements involved in any one of the two RF channels are mounted on one of opposite surfaces thereof, and the PA board may be stacked and disposed in the tile-type structure on any one of left and right sides of the plurality of one-side RF filters and the plurality of other-side RF filters, and the inner heat dissipation portion of the heat dissipation module may be stacked and arranged in the tile-type structure so as to be in surface thermal contact with an outer surface of the PA board.

A male socket portion for electrically coupling to the digital board by socket-pin engagement may be provided at a rear end of the PA board among opposite front and rear ends in a width direction thereof, and the digital board may be provided with a female socket portion to which the male socket portion of the PA board is coupled by the socket-pin engagement.

The outer heat dissipation portion of the heat dissipation module may be exposed to the outer space through an upper end of the antenna housing body, and a guide slot may be formed at the upper end of the antenna housing body to extend in a front-rear direction so as to guide insertion coupling when the PA board is coupled to the digital board by the socket-pin engagement.

The outer heat dissipation portion of the heat dissipation module may be exposed to the outer space through an upper end of the antenna housing body, and the antenna device may further include a finger guard panel assembly coupled to the antenna housing body so as to surround the outer heat dissipation portion exposed to the outer space through the upper end of the antenna housing body without contacting the outer heat dissipation portion.

The finger guard panel assembly may be configured to shield all portions of the outer heat dissipation portion exposed through the upper end of the antenna housing body except for a front portion thereof, and the antenna device may further include a radome panel configured to shield an opened front surface of the antenna housing body and formed of a material through which a beam radiated from the radiating element is transmitted, and a radome extension panel may be integrally formed at an upper portion of the radome panel to shield the front portion of the outer heat dissipation portion that is not shielded by the finger guard panel assembly.

A plurality of vent holes through which air of the outer space passes may be formed in at least a portion of the finger guard panel assembly and in the radome extension panel.

An antenna device according to another embodiment of the present disclosure includes an antenna housing body having a box shape with a front surface open and an installation space formed therein, a digital board stacked and coupled within the installation space such that a rear surface thereof is in close contact therewith, and having heat-generating elements mounted and disposed on at least one of opposite surfaces thereof, and an RF module for an antenna electrically signal-connected to the digital board, the RF module being vertically disposed in an up-down direction such that opposite surfaces thereof face left and right within the installation space, and the RF module for the antenna includes a radiating element having dual polarization, a first polarization antenna unit and a second polarization antenna unit each including an RF chain corresponding to each polarization of the radiating element so as to individually control the dual polarizations of the radiating element, and a heat dissipation module configured to dissipate heat generated from heat-generating surfaces of respective heat-generating elements provided in the first polarization antenna unit and the second polarization antenna unit, and the heat dissipation module is a panel-type heat exchanger, and heat-generating elements of the first polarization antenna unit and the second polarization antenna unit are disposed in surface thermal contact with one side and the other side thereof, respectively.

A lighting device according to one embodiment of the present disclosure includes a lighting body having a box shape with one surface open for light irradiation and an installation space formed therein, an LED board disposed in the installation space of the lighting body and having LED elements mounted on at least one of opposite surfaces thereof, and an LED module electrically signal-connected to the LED board and vertically disposed in an up-down direction within the installation space, and the LED module includes a heat dissipation module coupled to one surface or the other surface of the LED board in a vertical or horizontal direction so as to dissipate heat generated from heat-generating surfaces of the LED elements mounted on the LED board, and the heat dissipation module includes an inner heat dissipation portion extending into the installation space to receive and conduct heat from the LED elements, and an outer heat dissipation portion extending to the outside of the installation space to exchange heat transferred from the inner heat dissipation portion with air (outside air) in an outer space.

### [Advantageous Effects]

A heat dissipation module and a heat dissipation device, an RF module for an antenna, an antenna device, and a lighting device including the same according to one embodiment of the present disclosure can secure diversity in layout design of internal main functional elements of an electronic apparatus (electronic device).

In addition, the present disclosure has an effect of preventing performance degradation of functional elements by rapidly and efficiently dissipating system operating heat generated from functional elements provided within a closed installation space to the outside.

Furthermore, the present disclosure has an effect of significantly increasing a tilting range of a vertical beam by individually controlling signals of respective radiating elements at a digital domain without constructing the radiating elements as sub-arrays.

In addition, the present disclosure has an effect of efficiently dissipating heat generated from a heat-generating surface of an antenna unit, and of implementing Massive MIMO for 5G-Advanced to 6G next-generation communication without increasing the size of the antenna device by stacking a large number of antenna units in a stack-up structure and a tile-type structure.

### [Description of Drawings]

FIGS. 1A and 1B are perspective views illustrating a front exterior and a rear exterior of an antenna device according to one embodiment of the present disclosure, respectively;
FIGS. 2A and 2B are exploded perspective views of FIGS. 1A and 1B, respectively;
FIG. 3 is a perspective view illustrating a state in which a radome panel and a finger guard panel assembly are removed from the configuration of FIG. 1A;
FIG. 4 is an exploded perspective view of FIG. 3, illustrating a state in which a unit RF chain unit is coupled to an antenna housing body in the configuration of FIG. 3;
FIG. 5 is a rear perspective view illustrating a male socket portion of the unit RF chain unit of FIG. 4;
FIG. 6 is left and right perspective views illustrating the unit RF chain unit of FIG. 4;
FIGS. 7A and 7B are exploded perspective views of (a) and (b) of FIG. 6, respectively;
FIG. 8 is a perspective view illustrating antenna units for respective polarizations of radiating elements;
FIGS. 9A and 9B are exploded perspective views of (a) and (b) of FIG. 8, respectively;
FIG. 10 is a front view of FIG. 3;
FIG. 11 is a cross-sectional view taken along line A-A of FIG. 10;
FIG. 12 is a cutaway perspective view taken along line A-A of FIG. 10;
FIG. 13 includes a side view (a) of FIG. 8(a), a cross-sectional view (b) taken along line B-B, and a partially enlarged view thereof;
FIG. 14 is a perspective view illustrating another embodiment of an antenna unit in the configuration of an RF module for an antenna according to one embodiment of the present disclosure;
FIG. 15 is an exploded perspective view of FIG. 14;
FIG. 16 is a cross-sectional view taken along line C-C of FIG. 14; and
FIG. 17 is a partially cutaway perspective view and a partially enlarged perspective view from another angle, illustrating a lighting device including a heat dissipation module according to one embodiment of the present disclosure.

### <Description of reference numerals>

| | | | |
|---|---|---|---|
| 1: | Antenna device | 10: | Antenna housing body |
| 10S: | Installation space | 15: | Digital board |
| 16: | Female socket portion | 17: | Guide slot |
| 20: | Radome panel | 25: | Radome extension panel |
| 26, 36: | Vent holes | 30: | Finger guard panel assembly |
| 100: | RF module for antenna | 110: | Antenna unit |
| 120: | Radiating element | 130: | RF filter |
| 135: | Clamshell cover | 140: | PA board |
| 145: | Heat-generating elements (PA elements) | 150: | Heat dissipation module |
| 151: | Inner heat dissipation portion | 152: | Outer heat dissipation portion |
| 153, 154: | Strength reinforcing portions | 155: | Rim |

### [Mode for Invention]

Hereinafter, a heat dissipation module and a heat dissipation device, an RF module for an antenna, an antenna device, and a lighting device including the same according to one embodiment of the present disclosure are described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of one embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

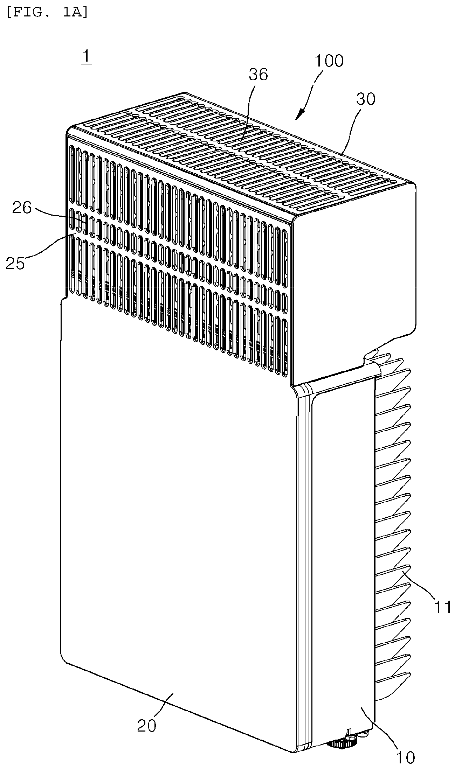

For example, FIGS. 1A to 16, which will be described below and are referenced to explain specific embodiments of the present disclosure, merely illustrate, by way of example, an antenna device which is one of representative products manufactured by the applicant of the present disclosure, and a lighting device which is one of representative products manufactured by an affiliate of the applicant of the present disclosure, since it is difficult to illustrate all types of electronic apparatuses (electronic devices). Thus, the meaning and scope of rights of the present disclosure should not be construed as being formally limited thereto.

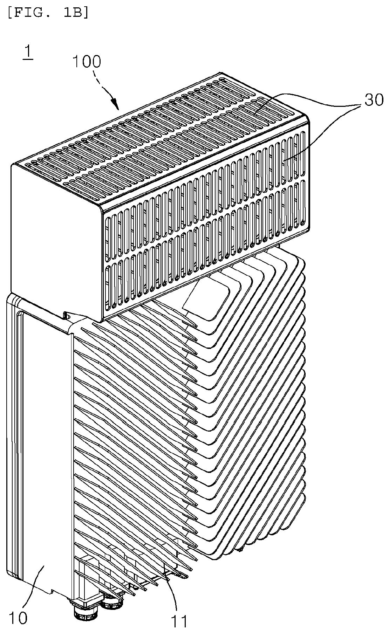

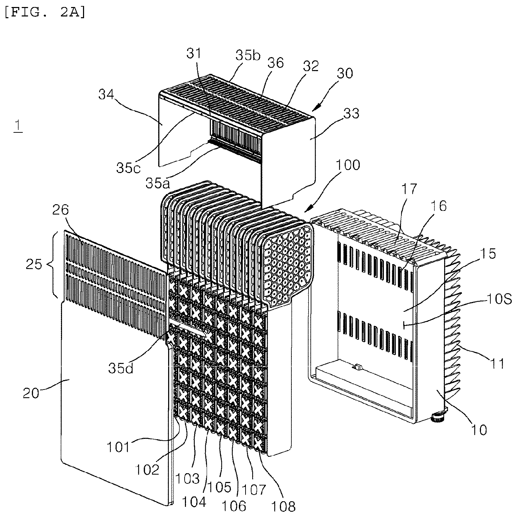

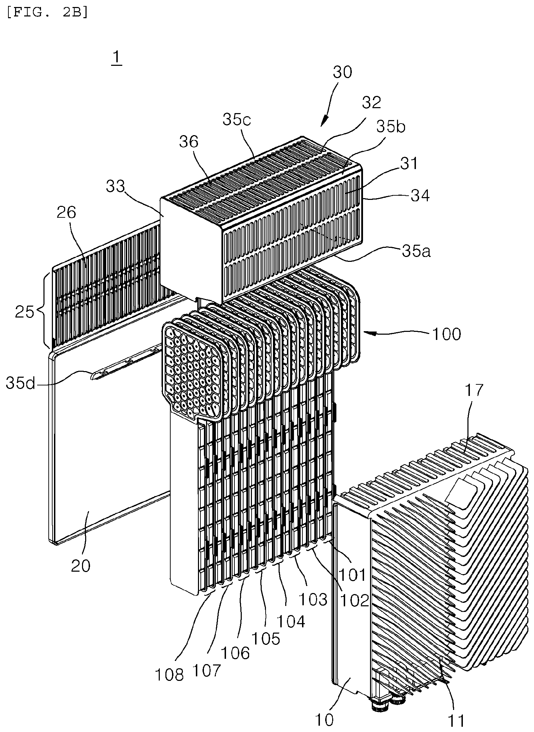

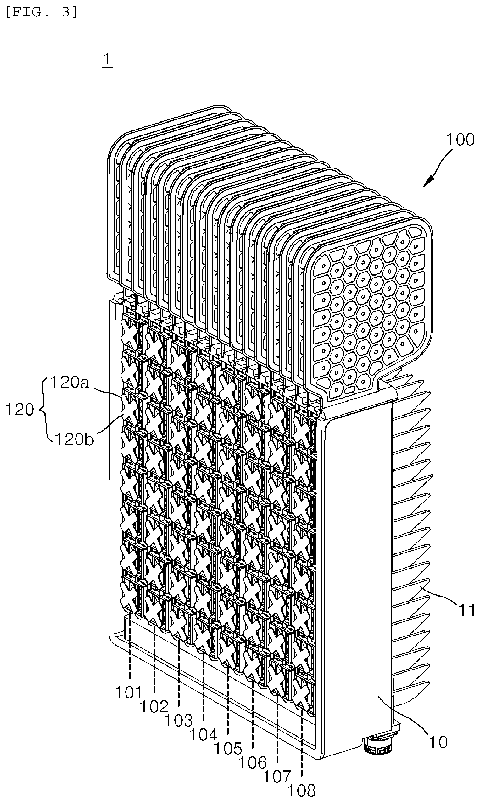

FIGS. 1A and 1B are perspective views illustrating a front exterior and a rear exterior of an antenna device according to one embodiment of the present disclosure, respectively, FIGS. 2A and 2B are exploded perspective views of FIGS. 1A and 1B, respectively, and FIG. 3 is a perspective view illustrating a state in which a radome panel and a finger guard panel assembly are removed from the configuration of FIG. 1A.

One embodiment of the present disclosure relates to a heat dissipation module 150 for dissipating heat generated from functional elements (e.g., see a PA element 145 and an LED element 145a described below) of an electronic apparatus (electronic device) to the outside.

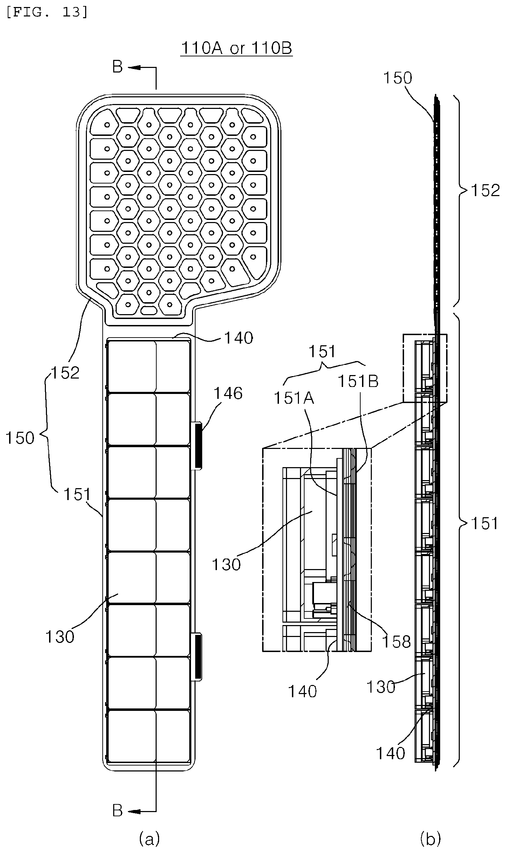

More specifically, the heat dissipation module 150 according to one embodiment of the present disclosure may include, as shown in FIGS. 1A to 3, a heat conduction panel body (no reference numeral assigned) having a refrigerant flow space (see reference numeral "158" in FIG. 13 described below) in which a refrigerant is accommodated and circulates between vapor and liquid phases within a closed space while undergoing a phase change to transfer heat.

Here, the refrigerant flow space 158 may include a first section (no reference numeral assigned), which is an evaporation region that receives heat from the heat-generating elements (see the PA element 145 and LED element 145a described below) to be cooled, and a second section (no reference numeral assigned), which is a path along which a liquid refrigerant, condensed from a vapor phase of the refrigerant into a liquid phase, flows to the first section by surface tension or gravity.

More specifically, in the refrigerant flow space 158, the first section is positioned closest to the heat-generating elements 145 and 145a, and serves as a portion to which the heat-generating elements 145 and 145a are directly coupled or coupled through a predetermined intermediary configuration, such that it may function as a kind of coupling end. The second section is a remaining portion of the refrigerant flow space 158 excluding the first section, and may function as a space through which the refrigerant flows to circulate between vapor and liquid phases within an entirely closed space.

The heat-generating elements 145 and 145a may be coupled to an outer side of the heat conduction panel body corresponding to the first section by either a fitting method or a joining method.

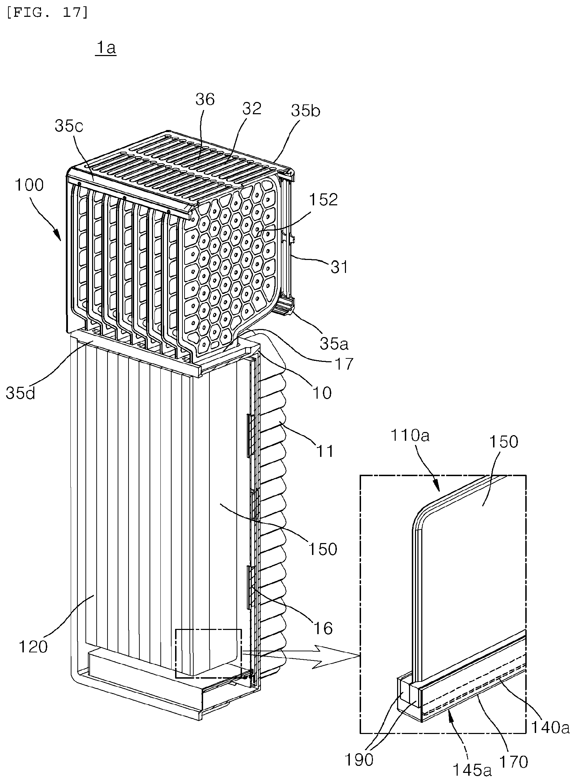

For example, the fitting method for the first section may be implemented, as shown in FIG. 17 described below, by fitting the coupling end corresponding to the first section into a support housing body 170, which is a coupling intermediary component of the heat conduction panel body. In this case, the first section is preferably set as a portion closest to the heat-generating elements 145 and 145a.

The above-described fitting coupling method between the first section and the heat-generating elements 145 and 145a will be described in more detail later.

Meanwhile, the first section of the refrigerant flow space 158 may be disposed within an inner space (corresponding to an installation space 10S of an antenna housing body 10 described below) in which the heat-generating elements 145 and 145a are arranged.

In addition, the second section of the refrigerant flow space 158 may be disposed such that at least a portion thereof is exposed to an outer space that is physically partitioned from the inner space (installation space 10S).

Here, the inner space may be interpreted as a space into which heat generated from functional elements (corresponding to the heat-generating elements denoted by reference numerals "145" and "145a") for driving the electronic apparatus (electronic device) is directly released, and may be typically construed as a closed space such as the installation space 10S of the antenna housing body 10 described below.

In addition, the outer space may be a space physically partitioned from the installation space 10S of the antenna housing body 10, and may be understood as a space in which outside air (outdoor air) freely flows in contrast to the inner space.

Here, when the inner space and the outer space are physically partitioned by the housing body 10 (having the same configuration as the antenna housing body 10), the first section of the refrigerant flow space 158 may be positioned relatively at a lower side with respect to a direction of gravity and disposed within the inner space of the housing body 10, and the second section of the refrigerant flow space 158 may be positioned relatively at an upper side with respect to the direction of gravity and disposed so as to be exposed to the outer space outside the housing body 10.

However, since the refrigerant flow space 158 is accommodated with a refrigerant as described above, the first section and the second section may be formed to communicate with each other such that, as the refrigerant undergoes a phase change, it circulates and flows between vapor and liquid phases from a lower end of the first section to an upper end of the second section.

In this manner, because the refrigerant needs to circulate between vapor and liquid phases between the first section and the second section of the refrigerant flow space 158, it is preferable that the heat conduction panel body be integrally formed. However, the heat conduction panel body is not necessarily required to be integrally formed from the first section to the second section.

For example, when a portion of the heat conduction panel body corresponding to the first section is defined as an inner heat dissipation portion 151, the inner heat dissipation portion 151 may be provided as either a heat pipe or a first phase-change fin, in which the refrigerant is accommodated and the accommodated refrigerant undergoes the phase change to circulate between vapor and liquid phases. In this case, the refrigerant in the first section and the refrigerant in the second section may communicate independently.

However, even when the first section and the second section communicate with each other, the heat conduction panel body does not need to be integrally formed. In this case, when a portion of the heat conduction panel body corresponding to the second section is defined as an outer heat dissipation portion 152, the outer heat dissipation portion 152 may be configured to communicate with the first section and may be provided in a form separately manufactured and coupled as a second phase-change fin in which the refrigerant, having undergone the phase change to the vapor phase in the first section, exchanges heat with outside air and is condensed into the liquid phase.

Meanwhile, the first phase-change fin and the second phase-change fin may be formed such that one surface is made of SUS and the other surface is made of Cu.

In particular, in a case where the heat-generating surfaces of the heat-generating elements 145 corresponding to the first section of the heat conduction panel body are coupled by a joining method through surface thermal contact, the surface (the other surface) that is in direct contact with the heat-generating surfaces of the heat-generating elements 145 is preferably made of Cu having relatively high thermal conductivity, and the opposite surface (the one surface) is preferably made of SUS.

Next, a heat dissipation device according to one embodiment of the present disclosure will be described in detail.

The heat dissipation device (no reference numeral assigned) according to one embodiment of the present disclosure, as shown in FIGS. 1A to 3, includes functional elements that are electrically driven and perform predetermined functions (e.g., among the components of the antenna device 1 shown in FIGS. 1A to 13 to be described later, radiating elements 120 and heat-generating elements (PA elements 145) for beam forming irradiation thereof, and the heat-generating elements (LED elements 145a) of the lighting device 1a shown in FIG. 17 to be described later), a plurality of device modules configured to control the functional elements 145 and 145a on a module-by-module basis (see an antenna unit 110 shown in FIGS. 1A to 13 to be described later and an LED module 110a shown in FIG. 17 to be described later), and a heat dissipation module 150 coupled to the device modules 110 and 110a in a vertical or horizontal direction so as to dissipate heat generated from heat-generating surfaces of the heat-generating elements 145 and 145a provided in the device modules 110 and 110a for each function.

Since the heat dissipation module 150 has been sufficiently described above, detailed descriptions of overlapping portions will be omitted. Hereinafter, representative electronic apparatuses (electronic devices) to which the heat dissipation module 150 according to one embodiment of the present disclosure may be directly applied, namely, an antenna device 1 and a lighting device 1a, which are representative products manufactured by the applicant of the present disclosure, will be described.

As shown in FIGS. 1A to 3, in the antenna device 1 according to one embodiment of the present disclosure, a plurality of radiating elements 120 may be vertically and horizontally arranged in an array antenna form on a front surface of the installation space 10S of the antenna housing body 10.

The array antenna refers to an antenna in which the plurality of radiating elements 120 are arranged at predetermined positions according to a predetermined pattern, and a beam is radiated in a predetermined direction by adjusting a phase and a magnitude according to the arrangement position of each radiating element 120.

Each individual radiating element 120 may be provided as a dual-polarized element configured to form ±45-degree polarized beams, in which feeder points (not shown) are arranged diagonally in an X-shaped configuration.

Each individual radiating element 120 is involved in 2T2R transmission and reception signals, and as shown in FIGS. 2A to 3, eight radiating elements are arranged in a vertical direction on the front surface of the antenna housing body 10 and eight radiating elements are arranged in a horizontal direction on the front surface thereof, thereby making it possible to implement Massive MIMO for 5G-Advanced to 6G next-generation communication having a total of 128 TRx transmission channels.

A representative example of an antenna device having a similar configuration is an AESA radar, which has been developed since 2016 under the supervision of the Agency for Defense Development and is a core piece of equipment mounted on the KF-X fighter aircraft.

AESA stands for Active Electronically Scanned Array and refers to an active electronically scanned phased array, and TR modules (TRMs) including antenna elements may be phased arrayed in a brick type and a tile type configuration.

In general, the brick-type phased array may include a PA (Power Amplifier) element, an LNA element, and a phase/gain controller, and a digital transmit/receive control unit.

Here, the brick-type phased array is arranged in a planar two-dimensional structure in which elements related to the above-described PA element, LNA element, phase/gain controller and digital transmit/receive control unit are mounted on a single board so that transmit and receive signals are transmitted in a direction parallel to a plane of the system module.

On the other hand, the tile-type phased array has a configuration similar to that of a general phased array applied to Massive MIMO technology manufactured by the applicant of the present disclosure. Thus, the RF module for the antenna and the antenna device to be described below are intended to fall within the scope of equivalents in terms of the heat dissipation function of the AESA radar.

In general, the beam forming may be classified into digital beam forming and analog beam forming. The analog beam forming refers to a method in which an analog signal, after digital signal processing is completed, is branched into multiple paths, and a beam is formed by setting a phase shift and power amplification in each path. The transmit and receive system has a structure including a plurality of phase shifters and signal attenuators together with a single RF chain.

The analog beam forming is a method of forming the direction and shape of the beam by varying the phase and amplitude values of the phase shifter and the signal attenuator connected to each individual antenna. Such an analog beam forming technique is vulnerable in terms of system performance and cost-effectiveness due to the limited resolution characteristics of the phase shifters and the high cost of components, and is structurally unsuitable for spatial multiplexing transmission techniques for high capacity.

In contrast, the digital beam forming is a technique in which a beam is formed at a digital domain using baseband processing of a base station to maximize diversity and multiplexing gains. In the digital beam forming, the RF chain is connected to each individual antenna, and RF circuits such as the phase shifter or the signal attenuator are not used. Based on such a system structure, the digital beam forming technique changes the phase and amplitude of signals through digital signal processing at the baseband, rather than varying the phase and amplitude of signals at the RF stage, thereby adjusting the beam angle.

In particular, the RF chain performs a function of adjusting a signal into a form suitable for transmission using a radio frequency antenna, or converting a signal received through the antenna element (radiating element) into a signal suitable for sampling and baseband processing.

However, in order to configure each RF chain, it is essential to include a filter, a Power Amplifier (PA), a Low Noise Amplifier (LNA), and an RFIC (in particular, the RFIC includes a Digital-to-Analog Converter (DAC), an Analog-to-Digital Converter (ADC), a mixer, and the like). To implement 128TRx equipment applicable to Massive MIMO for 5G-Advanced to 6G next-generation communication, beyond 64TRx equipment, the number of RF chains increases significantly, thereby causing problems related to heat dissipation and size.

In other words, since the size of the antenna device is determined according to each frequency band, when components for the increased number of RF chains are mounted on a planar board such as a main board to fit within that size, the number of mounted components becomes excessively large, resulting in a problem in that the size of the antenna device should be increased in practice, or the components should be densely and concentrically mounted within a limited space.

In particular, in the case of an array antenna having a large number of RF chains, it has conventionally been implemented as sub-arrays in order to make the antenna beam narrower. As additional sub-arrays are implemented, the number of radiating elements increases, and the design of the feed lines becomes more complex. Furthermore, there is a problem in that an analog phase shifter is required for phase adjustment between the existing array antenna and the sub-arrays.

For reference, the antenna device additionally implementing sub-arrays is advantageous in forming a narrow beam desired by a designer and in increasing the gain that determines the performance of the antenna device. In 64TRx configuration, the steering angle of a horizontal beam is preferably ±45 degrees, but the tilting angle of a vertical beam is limited to a very narrow range of about ±10 degrees, which poses a problem in that such a configuration is not suitable for low Earth orbit satellite communication services for recent drones or urban air mobility (UAM), in which a service altitude range of approximately 200 to 300 meters above ground level is formed.

In addition, the increase in the number of components described above ultimately leads to heat dissipation issues of system heat within the antenna housing body 10. Since it is generally difficult to construct a heat dissipation structure on the front side due to beam radiation, most of the heat generated from the heat-generating elements is dissipated toward the rear side through a plurality of heat sink fins 11 integrally formed on a rear surface of the antenna housing body 10, thereby forming a rear-side heat dissipation structure.

Therefore, the limitations of the rear-side concentrated heat dissipation structure ultimately lead to limitations in applying Massive MIMO technology for 5G-Advanced to 6G next-generation communication having 128 TRx transmission channels, and thus act as a significant difficulty in practical product manufacturing and design.

The antenna device 1 according to one embodiment of the present disclosure proposes a new technical configuration capable of not only forming a narrow beam desired by a designer in correspondence with the number of RF channels implemented based on 128 TRx without constructing the above-described sub-arrays, but also establishing an effective heat dissipation system.

As shown in FIGS. 1A to 3, the antenna device 1 according to one embodiment of the present disclosure includes an antenna housing body 10 having a rectangular parallelepiped box shape with a front surface open and an installation space 10S formed therein, a digital board 15 stacked and coupled to the installation space 10S of the antenna housing body 10 such that a rear surface thereof is in close contact therewith, heat-generating elements being mounted on at least one of opposite surfaces thereof, and an RF module 100 for an antenna electrically signal-connected to the digital board 15 and vertically arranged in an up-down direction such that opposite surfaces thereof face left and right within the installation space 10S.

Here, the installation space 10S defined in the antenna housing body 10 may be elongated in the vertical direction, and a width between left and right ends may be greater than a thickness in a front-rear direction. The front side of the installation space 10S is open, and a radome panel 20 described below may be coupled thereto to shield the installation space 10S.

Meanwhile, although referred to as the digital board, the digital board 15 stacked and coupled to the installation space 10S of the antenna housing body 10 may be understood as encompassing general PCBs and PBAs. However, in the embodiment of the present disclosure, it should be noted that this term is given in that the heat-generating elements performing analog functions in the RF module 100 for the antenna are mounted separately from the heat-generating elements mounted on the digital board 15.

The heat-generating elements mounted on the digital board 15, although not shown in the drawings, may be distributedly mounted on the rear surface of the digital board 15 among opposite surfaces thereof so that rear heat dissipation is smoothly performed through the plurality of heat sink fins 11 integrally formed on the rear portion of the antenna housing body 10. These heat-generating elements may typically include FPGA elements and the like.

The antenna housing body 10 may be made of a metal material having excellent thermal conductivity so as to easily transfer system heat generated within the installation space 10S to the outside. On the rear surface of the antenna housing body 10, the plurality of heat sink fins 11 may be integrally formed in a predetermined pattern so as to receive system heat including heat generated from the heat-generating elements of the digital board 15 and to increase a heat exchange area with outside air at the rear portion.

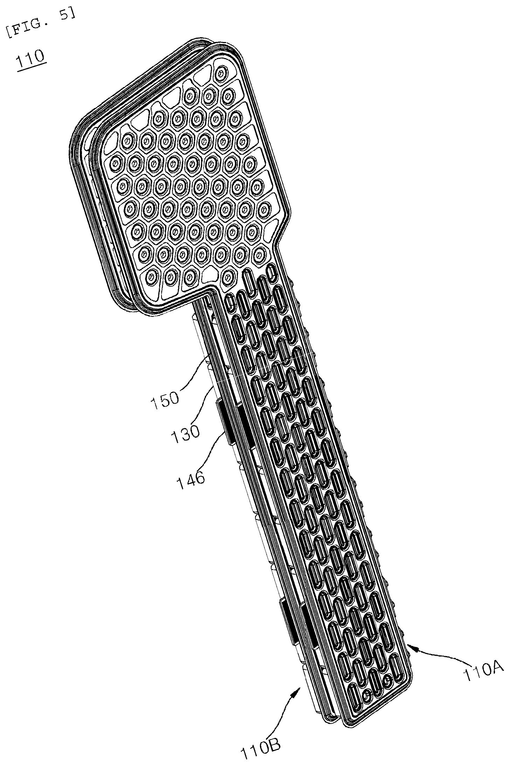

As shown in FIGS. 1A to 3, the RF module 100 for the antenna according to one embodiment of the present disclosure may include a radiating element 120 having at least one polarization, and a plurality of antenna units (see reference numeral 110 in FIG. 5), each including an RF chain (no reference numeral assigned) corresponding to each polarization of the radiating element 120 to individually control the polarization of the radiating element 120.

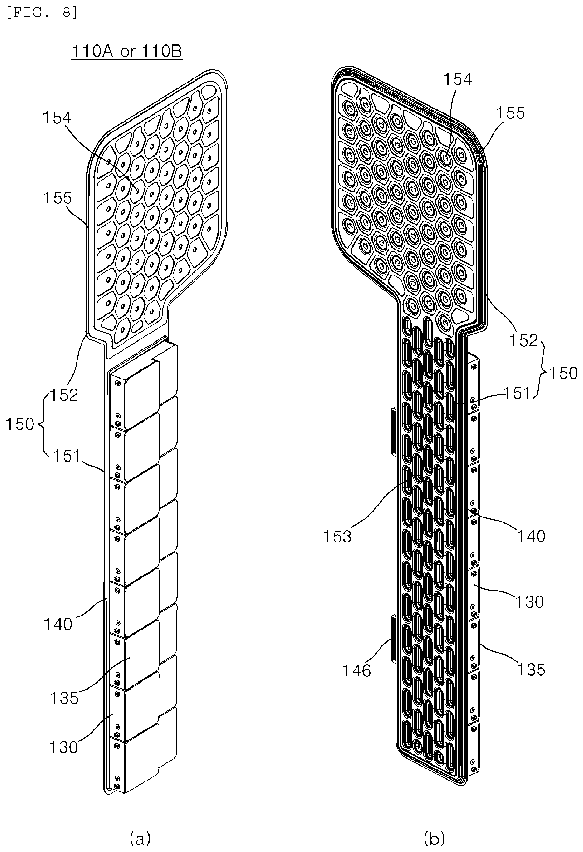

The plurality of antenna units 110 may be provided with a first polarization antenna unit (see reference numeral 110A in FIG. 8 described below) involved in one polarization and a second polarization antenna unit (see reference numeral 110B in FIG. 8 described below) involved in another polarization, with respect to eight radiating elements 120 arranged to implement 2TRx per unit so as to realize a large number of RF channels corresponding to the 128TRx configuration and to enable a greater number of beam radiations to be performed without mutual interference.

A detailed description of the specific configuration and functions of the first polarization antenna unit 110A and the second polarization antenna unit 110B will be provided later.

Meanwhile, as shown in FIGS. 1A to 3, the RF module 100 for the antenna according to one embodiment of the present disclosure may further include a heat dissipation module 150 coupled to the antenna units 110 in a vertical or horizontal direction so as to dissipate heat generated from the heat-generating surfaces of the heat-generating elements (e.g., see PA elements 145 described below) provided in the antenna units 110A and 110B for each polarization among the plurality of adjacent antenna units 110.

Here, as described above, the heat dissipation module 150 may include a heat conduction panel body having a refrigerant flow space 158, which is a space in which a refrigerant is accommodated and circulates between vapor and liquid phases within a closed space while undergoing a phase change to dissipate heat.

In addition, the refrigerant flow space 158 may include a first section, which is an evaporation region that receives heat from the heat-generating elements 145 to be cooled, and a second section, which is a path along which a liquid refrigerant, condensed from a vapor phase of the refrigerant into a liquid phase, flows to the first section by surface tension or gravity.

Meanwhile, as shown in FIGS. 1A to 3, the heat dissipation module 150 may include an inner heat dissipation portion 151 that extends into the installation space 10S of the antenna housing body 10 to receive and conduct heat from the heat-generating elements 145, and an outer heat dissipation portion 152 that extends to an outside of the installation space 10S to exchange heat, transferred from the inner heat dissipation portion 151, with air in an outer space (outside air).

Here, the inner heat dissipation portion 151 may be defined as including the above-described first section and at least a portion of the second section, and the outer heat dissipation portion 152 may be defined as including only the second section.

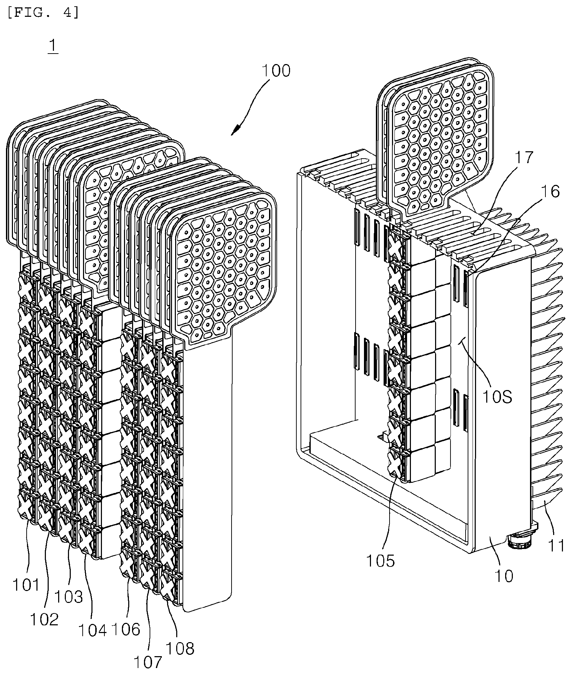

FIG. 4 is an exploded perspective view of FIG. 3, illustrating a state in which a unit RF chain unit is coupled to the antenna housing body in the configuration of FIG. 3, and FIG. 5 is a rear perspective view illustrating a male socket portion of the unit RF chain unit of FIG. 4.

As shown in FIGS. 4 and 5, the plurality of antenna units 110 may be coupled to be electrically signal-connected to the digital board 15, which is pre-stacked and arranged in module units within the installation space 10S of the antenna housing body 10. The inner heat dissipation portion 151 of the heat dissipation module 150 may be positioned inside the installation space 10S, while the outer heat dissipation portion 152 may be installed so as to be exposed to the outside of the antenna housing body 10 (more specifically, to an upper outer space of the antenna housing body 10).

To this end, guide slots 17 for installation of the plurality of antenna units 110 on a module-by-module basis may be formed on an upper end of the antenna housing body 10 to extend in a front-rear direction. The installation process of the plurality of antenna units 110 into the antenna housing body 10 through the guide slots 17 will be described in more detail later.

Meanwhile, as shown in FIGS. 1A to 5 (particularly FIGS. 2A and 2B), the antenna device 1 according to one embodiment of the present disclosure may further include a finger guard panel assembly 30 coupled to the antenna housing body 10 so as to surround the outer heat dissipation portion 152, exposed to an outer space through the upper end of the antenna housing body 10, without contacting it when the outer heat dissipation portion 152 of the heat dissipation module 150 is installed to be exposed to the outer space through the upper end of the antenna housing body 10.

The finger guard panel assembly 30 may be provided to shield all portions of the outer heat dissipation portion 152 exposed through the upper end of the antenna housing body 10 except for a front portion thereof.

More specifically, as shown in FIGS. 2A and 2B, the finger guard panel assembly 30 may include a rear shielding panel 31 installed upright to shield a rear portion of the outer heat dissipation portion 152, an upper shielding panel 32 connected to an upper end of the rear shielding panel 31 and installed horizontally to shield an upper portion of the outer heat dissipation portion 152, and a left shielding panel 33 and a right shielding panel 34 which have rear ends and upper ends connected to the rear shielding panel 31 and the upper shielding panel 32, respectively and are installed upright to shield side portions of the outer heat dissipation portions 152 of the heat dissipation modules 150 provided at a leftmost side and a rightmost side of the antenna housing body 10 among the plurality of heat dissipation modules 150.

The finger guard panel assembly 30 may further include a rear lower mounting bar 35a that mediates coupling between a lower end of the rear shielding panel 31 and a rear upper surface of the antenna housing body 10, a rear upper mounting bar 35b that mediates coupling between an upper end of the rear shielding panel 31 and a rear end of the upper shielding panel 32, a front upper mounting bar 35c that mediates coupling between a front end of the upper shielding panel 32 and an upper end of the radome panel 20 described below, and a front lower mounting bar 35d that mediates coupling between a radome extension panel 25 described below, which performs a function similar to that of the finger guard panel assembly 30 in the radome panel 20, and a front upper surface of the antenna housing body 10.

At least a portion of the finger guard panel assembly 30 (in the embodiment of the present disclosure, the rear shielding panel 31 and the upper shielding panel 32) may be provided with a plurality of vent holes 36 through which air in the outer space (outside air) may pass.

Meanwhile, as shown in FIGS. 1A to 3, the installation space 10S of the antenna housing body 10 having the open front surface may be configured to be shielded by the radome panel 20.

The radome panel 20 may be formed of a material that protects various components provided within the installation space 10S from an external environment while allowing beams radiated from the radiating elements 120 to be smoothly transmitted therethrough.

Meanwhile, an upper portion of the radome panel 20 may be integrally formed with the radome extension panel 25 that shields the front portion of the outer heat dissipation portion 152 not covered by the finger guard panel assembly 30.

Here, it is to be understood that a plurality of vent holes 26 through which air in the outer space may pass may also be formed in the radome extension panel 25 so as to facilitate heat exchange with the outer heat dissipation portion 152.

However, although the portion in which the outer heat dissipation portion 152 is located is a space shielded by the finger guard panel assembly 30 and the radome extension panel 25, it may still be defined as an "outer space" in that outside air may freely flow in and out through the above-described plurality of vent holes 36 and 26.

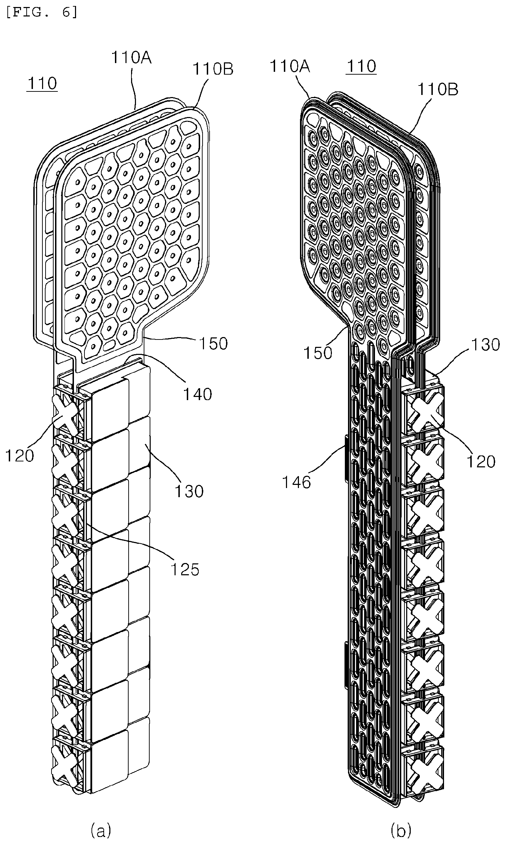

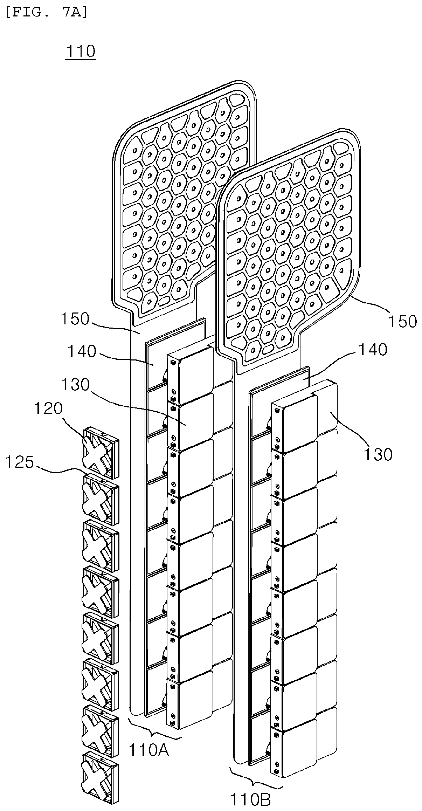

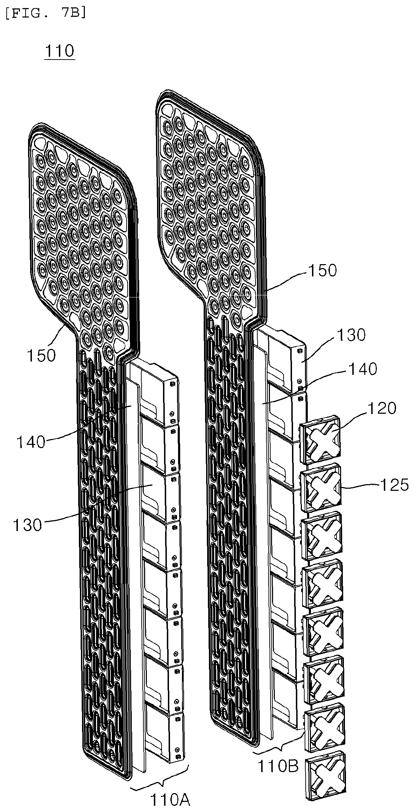

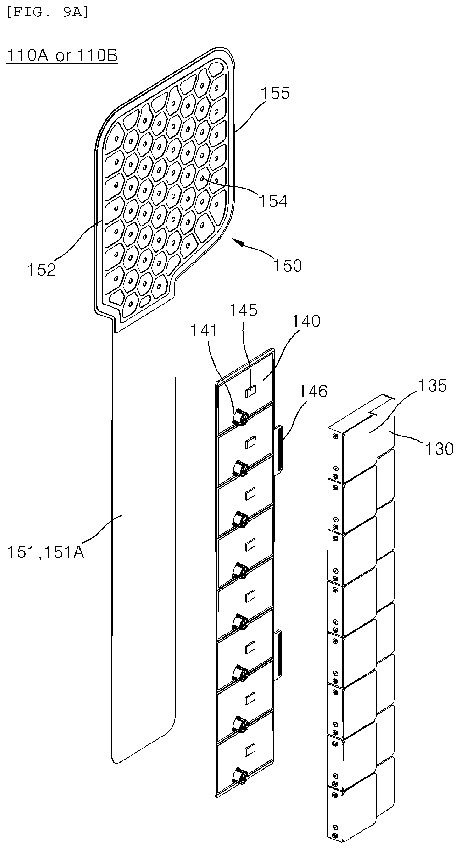

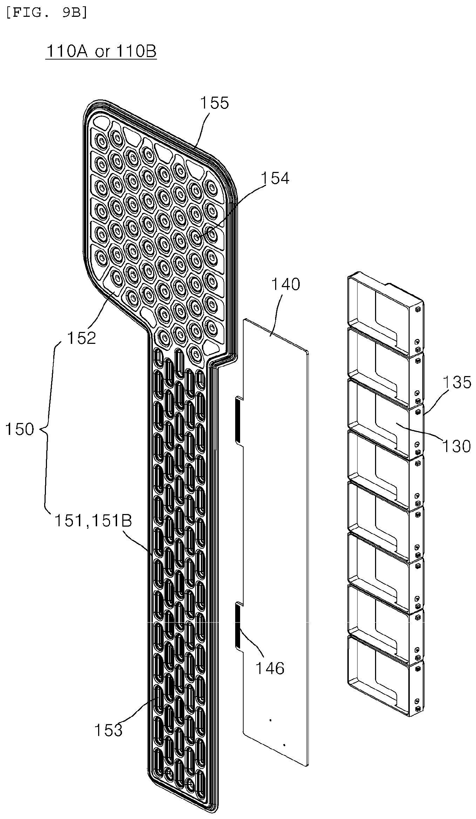

FIG. 6 is left and right perspective views illustrating the unit RF chain unit of FIG. 4, FIGS. 7A and 7B are exploded perspective views of (a) and (b) of FIG. 6, respectively, FIG. 8 is a perspective view illustrating antenna units for respective polarizations of radiating elements, and FIGS. 9A and 9B are exploded perspective views of (a) and (b) of FIG. 8, respectively.

Hereinafter, the RF module 100 for the antenna coupled to the digital board 15 in the installation space 10S of the antenna housing body 10 will be described in detail.

As shown in FIGS. 6 to 10, the RF module 100 for the antenna according to one embodiment of the present disclosure includes a radiating element 120 having at least one polarization, a plurality of antenna units 110 each including an RF chain corresponding to each polarization of the radiating elements 120 so as to individually control the polarization of the radiating element 120, and a heat dissipation module 150 coupled to the antenna unit 110 in a vertical or horizontal direction so as to dissipate heat generated from the heat-generating surfaces of the heat-generating elements (e.g., PA elements denoted by reference numeral 140) provided in the antenna units 110A and 110B for each polarization among a plurality of adjacent antenna units 110.

Here, the plurality of antenna units 110 may be stacked and arranged on the installation space 10S of the antenna housing body 10 to have eight rows in a left-right horizontal direction.

The term "stack" used hereinafter will be defined as being classified into two types as follows.

For example, assuming that a radiation direction of the radiating elements 120 is forward, and that the installation space 10S of the antenna housing body 10 is provided in the shape of a rectangular parallelepiped box having an open front surface, being elongated in an up-down direction and having a shorter width in a left-right direction, a continuous arrangement in the up-down direction is defined as "stack-up stacking," and a continuous arrangement in the left-right direction is defined as "tile-type stacking."

However, the term "stack" used in describing the embodiment of the present disclosure is merely for clearer understanding of the present disclosure, and the scope of rights of the present disclosure should not be construed as being limited by the described terminology.

As shown in FIGS. 1A to 9B, the RF module 100 for the antenna according to one embodiment of the present disclosure may include a first polarization antenna unit 110A involved in one polarization of the radiating element 120 configured to radiate a dual-polarized beam, and a second polarization antenna unit 110B involved in another polarization of the radiating element 120 configured to radiate the dual-polarized beam.

Here, the first polarization antenna unit 110A may include a plurality of one-side RF filters 130A arranged in a stack-up configuration in a single row in an up-down direction and stacked in a tile-type structure vertically such that opposite ends in a longitudinal direction are positioned at front and rear, respectively. The second polarization antenna unit 110B may further include a plurality of other-side RF filters 130B arranged in a stack-up configuration in a single row in the up-down direction to be stacked in a left-right direction with respect to one of left and right sides of the plurality of one-side RF filters 130A and stacked in a tile-type structure vertically such that opposite ends in the longitudinal direction are positioned at front and rear, respectively.

In addition, a clamshell cover 135 may be disposed on outer surfaces of the one-side RF filters 130A and the other-side RF filters 130B to block external signal interference with adjacent PA boards 140 and RF filters 130.

Meanwhile, the radiating element 120 may include a first polarization element 120a connected to a signal transmitted along a one-side feeder line and arranged to be connected to the plurality of one-side RF filters 130A, and a second polarization element 120b connected to a signal transmitted along an other-side feeder line and arranged to be connected to the plurality of other-side RF filters 130B.

Here, the first polarization element 120a and the second polarization element 120b may be seated on front ends of the plurality of one-side RF filters 130A and the plurality of other-side RF filters 130B such that one end and the other end thereof cross each other.

In addition, front end surfaces of the plurality of one-side RF filters 130A and the plurality of other-side RF filters 130B may serve as reflectors that reflect beams radiated from the radiating elements 120 forward. That is, although not shown in the drawings, a predetermined metal coating may be integrally formed on the front end surfaces of the plurality of one-side RF filters 130A and the plurality of other-side RF filters 130B through a coating process, thereby allowing the coated structure itself to perform a reflector function.

Meanwhile, the radiating element 120 may further include a base panel 125 that is disposed to partition between the plurality of one-side RF filters 130A and the plurality of other-side RF filters 130B and the first polarization element 120a and the second polarization element 120b and supports the first polarization element 120a and the second polarization element 120b.

Here, the base panel 125 may have a forward protruding height that blocks radiation beams radiated from the first polarization element 120a and the second polarization element 120b from being radiated toward adjacent radiating elements 120.

In particular, the base panel 125 may be installed to be supported forward by the PA board 140 among the components of the plurality of antenna units 110.

In this manner, among the plurality of one-side RF filters 130A and the plurality of other-side RF filters 130B, filters (elements) arranged in the tile-type stacked structure at the same position in the vertical direction constitute two RF channels.

More specifically, the antenna units 110 may include a plurality of combinations (see reference numerals 101 to 108 in FIGS. 2A to 4) of one-side RF filters 130A and other-side RF filters 130B that implement 2T2R transmission paths, which are arranged in a stack-up stacking and tile-type stacking configuration, thereby implementing a total of 128 TRx transmission paths.

Each of the plurality of antenna units 110 may further include a one-side feeder line and an other-side feeder line (not shown) for supplying predetermined electrical signals to the plurality of one-side RF filters 130A and the plurality of other-side RF filters 130B constituting two RF channels, and a PA board 140 on which heat-generating elements involved in one of the two RF channels are mounted on one of opposite surfaces thereof.

In particular, on at least one surface of the PA board 140, a plurality of PA elements (Power Amplifiers, 145), which are power amplification elements, may be mounted and arranged, and heat generated from the PA elements 145 may be dissipated to the outside of the antenna housing body 10 by the heat dissipation module 150.

However, the heat-generating elements mounted on the PA board 140 are not necessarily limited to the PA elements 145, and may further include any one of a Low Noise Amplifier (LNA) or an RFIC.

Meanwhile, a male socket portion 146 for electrically coupling to the digital board 15 by socket-pin engagement may be provided at a rear end among opposite front and rear ends in a width direction of the PA board 140. The male socket portion 146 may be formed to protrude further rearward than the rear end of the PA board 140.

In addition, a female socket portion 16 to which the male socket portion 146 of the PA board 140 is coupled by the socket-pin engagement may be provided on the front surface of the digital board 15.

Since the outer heat dissipation portion 152 of the heat dissipation module 150 is exposed to the outer space through the upper end of the antenna housing body 10, the plurality of antenna units 110 may be module-coupled while being guided by the guide slot 17 provided on the upper end of the antenna housing body 10 so as to guide insertion coupling when the PA board 140 is socket-pin coupled to the digital board 15.

As described above, in the antenna device 1 according to one embodiment of the present disclosure, unlike a case in which digital elements and analog elements are intensively mounted on a single board such as the digital board 15 disposed in the installation space 10S of the antenna housing body 10 without separation, some of the heat-generating elements (e.g., PA elements 145) are distributed to the PA boards 140 of polarization-specific antenna units (the first polarization antenna unit 110A and the second polarization antenna unit 110B) among the plurality of antenna units 110 involved in respective RF channels, and arranged in the stack-up stacking and tile-type stacking configuration. This arrangement enables individual beam forming control for a large number of RF chains without implementing sub-arrays.

In addition, the heat dissipation module 150 described below is designed and manufactured in a structure suitable for efficient external heat dissipation from the heat-generating elements 145 of the PA board 140 arranged in a stack-up stacking and tile-type stacking configuration, thereby enabling complete implementation of individual beam forming control for the above-described large number of RF chains and narrow beam design for each beam.

More specifically, as shown in FIGS. 6 to 9B, the heat dissipation module 150 is disposed in surface thermal contact with outer surfaces of the PA boards 140 of the first polarization antenna unit 110A and the second polarization antenna unit 110B, respectively, thereby serving to receive and dissipate heat generated from the plurality of heat-generating elements 145.

That is, the heat dissipation module 150 may include a first heat dissipation portion 150-1 disposed in surface thermal contact with the heat-generating elements 145 mounted on the PA board 140 of the first polarization antenna unit 110A, and a second heat dissipation portion 150-2 disposed in surface thermal contact with the heat-generating elements 145 mounted on the PA board 140 of the second polarization antenna unit 110B.

Thus, between the first heat dissipation portion 150-1 and the second heat dissipation portion 150-2, either the plurality of one-side RF filters 130A or the plurality of other-side RF filters 130B may be arranged in the stack-up stacking configuration, depending on the direction thereof.

For example, on an inner surface of the first heat dissipation portion 150-1 facing the second heat dissipation portion 150-2, the plurality of one-side RF filters 130A involved in one polarization of the dual polarization may be arranged in the stack-up stacking configuration, and a one-side PA board 140-1 involved in the one polarization of the dual polarization may be disposed between the first heat dissipation portion 150-1 and the plurality of one-side RF filters 130A.

Similarly, on an outer surface of the second heat dissipation portion 150-2, a plurality of other-side RF filters 130B involved in the other polarization of the dual polarization may be arranged in the stack-up stacking configuration, and an other-side PA board 140-2 involved in the other polarization of the dual polarization may be disposed between the second heat dissipation portion 150-2 and the plurality of other-side RF filters 130B.

As described above, as shown in FIGS. 6 to 9B, the RF module 100 for the antenna according to one embodiment of the present disclosure may be provided such that the first heat dissipation portion 150-1 and the second heat dissipation portion 150-2 individually dissipate heat generated from the heat-generating elements 145 of the one-side PA board 140-1 and the other-side PA board 140-2 for each polarization.

In particular, although not shown in the drawings, a Package On Board (POB) surface mounting technology (SMT) for electronic components may be applied as a joining method that enables surface thermal contact between the one-side PA board 140-1 and the other-side PA board 140-2 and the respective outer surfaces of the first heat dissipation portion 150-1 and the second heat dissipation portion 150-2.

However, in the case of the POB method, since a soldering material (not shown) should necessarily be applied to join between an outer surface of the first heat dissipation portion 150-1 or the second heat dissipation portion 150-2 and the one-side PA board 140-1 or the other-side PA board 140-2 formed of a PCB material, and since thermal transfer resistance inevitably occurs due to the applied soldering material, a joining method in which the heat-generating elements 145 mounted directly on the one-side PA board 140-1 or the other-side PA board 140-2 are brought into surface thermal contact with the outer surface of the first heat dissipation portion 150-1 or the second heat dissipation portion 150-2 may be more advantageous.

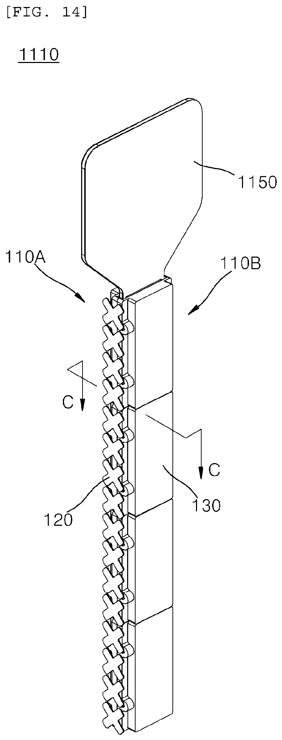

Hereinafter, the configuration in which heat generated from the heat-generating elements 145 of the one-side PA board 140-1 and the other-side PA board 140-2 for each polarization is dissipated by the two heat dissipation portions 150-1 and 150-2 as described above will be defined as an antenna unit 110 according to one embodiment, and one embodiment to be described below with reference to FIGS. 14 to 16 will be defined as an antenna unit 1110 according to another embodiment.

That is, in the RF module 100 for the antenna according to the present disclosure, the antenna unit is not necessarily required to include two heat dissipation portions 150-1 and 150-2 to perform heat dissipation for each polarization as in the above-described embodiment. Rather, it may be configured such that heat-generating elements 145 of the one-side PA board 140-1 and the other-side PA board 140-2 are arranged to be simultaneously in surface thermal contact with left and right surfaces, respectively, of a single heat dissipation module 1150. This will be described in more detail later.

In particular, as already described in detail, the heat dissipation module 150 includes the inner heat dissipation portion 151 that is in surface thermal contact with one surface of the PA board 140 on which the plurality of heat-generating elements 145 are mounted, and the outer heat dissipation portion 152 that releases heat transferred from the inner heat dissipation portion by exchanging heat with outside air.

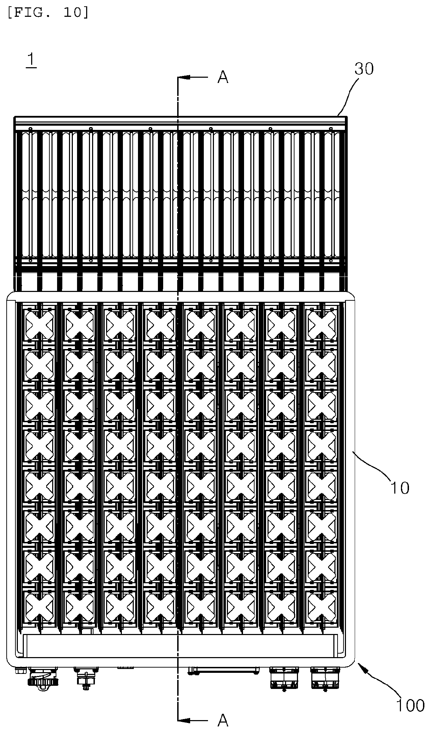

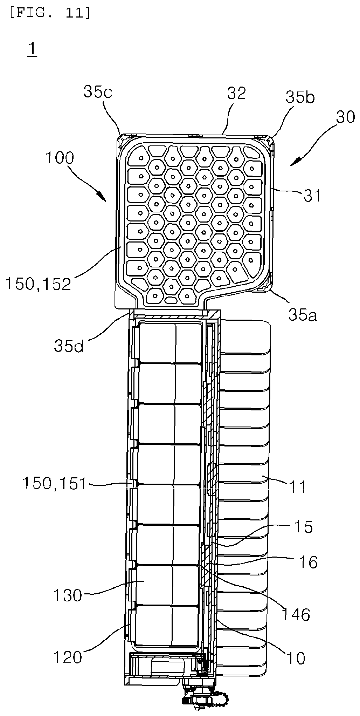

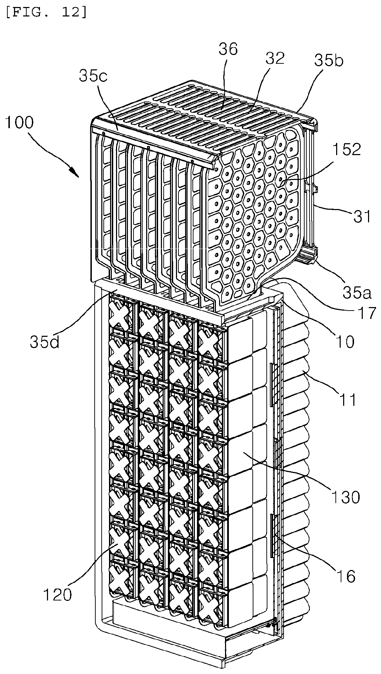

FIG. 10 is a front view of FIG. 3, FIG. 11 is a cross-sectional view taken along line A-A of FIG. 10, FIG. 12 is a cutaway perspective view taken along line A-A of FIG. 10, and FIG. 13 includes a side view (a) of FIG. 8(a), a cross-sectional view (b) taken along line B-B, and a partially enlarged view thereof.

As shown in FIGS. 10 to 13, the inner heat dissipation portion 151 and the outer heat dissipation portion 152 constituting the heat dissipation module 150 may be formed to communicate with each other such that the refrigerant is accommodated therein and the accommodated refrigerant circulates between vapor and liquid phases.

Here, although not shown in the drawings, the inner heat dissipation portion 151 may be provided as a plurality of heat pipes which accommodate the refrigerant therein and in which the accommodated refrigerant undergoes phase change and circulates in the gas-liquid phase.

However, the inner heat dissipation portion 151 is not necessarily required to be provided as the heat pipe. As shown in FIGS. 10 to 13, it may alternatively be provided as a first phase-change fin (no reference numeral assigned) of a panel-type heat exchanger (PTX), in which a refrigerant is accommodated and the accommodated refrigerant undergoes phase change to circulate between vapor and liquid phases.

In addition, as shown in FIGS. 10 to 13, the inner heat dissipation portion 151 and the outer heat dissipation portion 152 may be provided as a second phase-change fin (no reference numeral assigned) of a panel-type heat exchanger, which is formed so that a refrigerant is accommodated therein and the inner and outer heat dissipation portions communicate with each other to allow the accommodated refrigerant to circulate between vapor and liquid phases from the inner heat dissipation portion 151 to the outer heat dissipation portion 152.

Here, the inner heat dissipation portion 151 and the outer heat dissipation portion 152 may be manufactured by joining edges 155 of two metal panel members 151A and 151B fabricated by a press forming process to form the refrigerant flow space 158, in which the refrigerant is accommodated.

In particular, the two metal panel members 151A and 151B may be formed with a plurality of strength reinforcement portions 153 and 154, which are processed and formed by the press forming process to reinforce structural rigidity thereof and to be joined to each other at least within the refrigerant flow space 158.

More specifically, the plurality of strength reinforcement portions 153 and 154 may be formed to protrude by a predetermined length in a circular or oval shape toward the refrigerant flow space 158 from one surface of the two metal panel members 151A and 151B constituting the inner heat dissipation portion 151 and the outer heat dissipation portion 152, respectively, through a press forming process.

Here, in the case where the inner heat dissipation portion 151 is provided as the first phase-change fin of the panel-type heat exchanger, one surface thereof that is in surface thermal contact with one surface of the PA board 140 may be made of Cu, and the other surface thereof that is not in surface thermal contact with the one surface of the PA board 140 may be made of SUS. This is because, if the inner heat dissipation portion 151 is made only of SUS, surface bonding between the SUS surface and the surface of the PA board 140 is difficult; therefore, Cu, which facilitates bonding to the surface of the PA board 140, may be adopted.

However, since the outer heat dissipation portion 152 is not intended to be surface-bonded (surface thermal contact) to the PA board 140, and on the premise that the above-described disadvantages of surface bonding may be overcome, it is to be understood that both the outer heat dissipation portion 152 and the inner heat dissipation portion 151 provided as the second phase-change fin of the panel-type heat exchanger may be formed of SUS on opposite surfaces.

For example, the outer heat dissipation portion 152 provided as the second phase-change fin of the panel-type heat exchanger may be formed of SUS on opposite surfaces, while the inner heat dissipation portion 151 provided as the second phase-change fin of the panel-type heat exchanger may be formed such that one surface in surface thermal contact with one surface of the PA board 140 is made of Cu and the other surface not in surface thermal contact with the one surface of the PA board 140 is made of SUS.

Meanwhile, the refrigerant accommodated in the refrigerant flow space 158 of the heat dissipation module 150 may be water that does not cause a chemical reaction with the metal materials constituting the two metal panel members 151A and 151B. For reference, when water is adopted as the refrigerant, it is preferable to exclude aluminum (Al) from the metal materials constituting the heat dissipation module 150. This is because aluminum (Al), due to its material characteristics, may undergo an oxidation reaction when in contact with water, thereby generating a certain amount of hydrogen gas and increasing the internal pressure of the refrigerant flow space 158.

As described above, the two metal panel members 151A and 151B are formed by a press forming process, and the inner heat dissipation portion 151 of the heat dissipation module 150, in which the refrigerant flow space 158 is formed to allow the refrigerant accommodated therein to circulate between vapor and liquid phases through phase change, is provided to be in surface thermal contact with one surface of the PA board 140 on which the heat-generating elements 145 separated from the digital board 15 are mounted, thereby rapidly inducing phase change of the accommodated liquid refrigerant into a gas refrigerant and allowing the evaporated gas refrigerant to be dispersed and flow toward the outer heat dissipation portion 152, thereby enabling efficient dissipation of system heat based on a 128TRx configuration.

Meanwhile, the refrigerant flow space 158 of the inner heat dissipation portion 151, which is in surface thermal contact with one surface of the PA board 140, may further include an absorber (not shown) that collects liquid refrigerant and evaporates the collected liquid refrigerant into gas refrigerant by heat transferred from the heat-generating elements 145.

Here, the absorber is preferably arranged to occupy only a half portion of the thickness of the refrigerant flow space 158 of the inner heat dissipation portion 151, specifically the half adjacent to the PA board 140.

This is to allow active vaporization of the liquid refrigerant in the half portion of the thickness of the refrigerant flow space 158 of the inner heat dissipation portion 151 where the absorber is provided, and thereafter to allow the gas refrigerant to freely flow toward the outer heat dissipation portion 152, thereby allowing the remaining half portion to provide a flow path therefor.

More preferably, when the inner heat dissipation portion 151 is provided as the first phase-change fin of the panel-type heat exchanger, the absorber may be disposed only in the half portion corresponding to one surface made of Cu that is in surface thermal contact with one surface of the PA board 140.

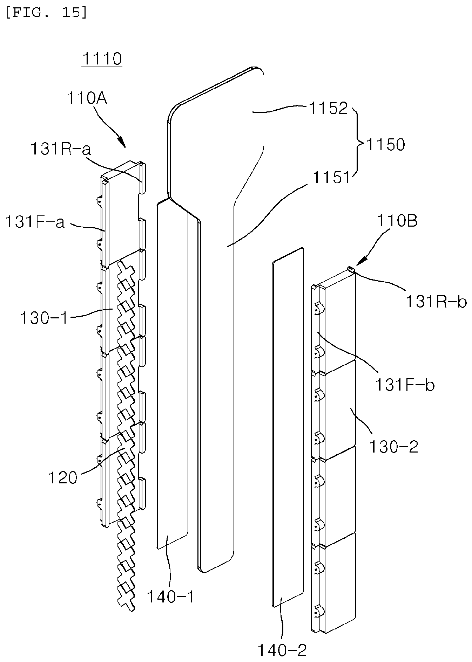

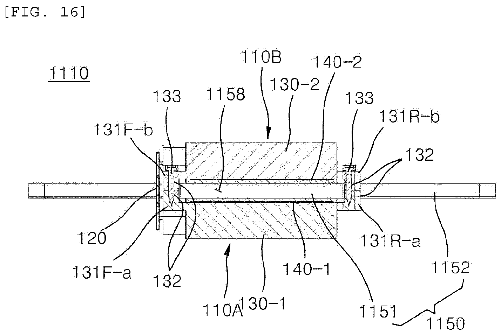

FIG. 14 is a perspective view illustrating another embodiment of an antenna unit in the configuration of an RF module 100 for an antenna according to one embodiment of the present disclosure, FIG. 15 is an exploded perspective view of FIG. 14, and FIG. 16 is a cross-sectional view taken along line C-C of FIG. 14.

Referring to FIGS. 14 to 16, an antenna unit 1110 according to another embodiment of the present disclosure may include a single heat dissipation module 1150 provided in a panel-type heat exchanger configuration, a one-side PA board 140-1 bonded to one surface of the heat dissipation module 1150, and an other-side PA board 140-2 bonded to the other surface of the heat dissipation module 1150.

In addition, the antenna unit 1110 according to another embodiment of the present disclosure may further include a one-side RF filter 130-1 stacked on an outer surface of the one-side PA board 140-1 to provide bonding force of the one-side PA board 140-1 to the single heat dissipation module 1150, and an other-side RF filter 130-2 stacked on an outer surface of the other-side PA board 140-2 to provide bonding force of the other-side PA board 140-2 to the single heat dissipation module 1150.

Here, the one-side PA board 140-1 and the one-side RF filter 130-1, which are stacked and disposed on one surface of the single heat dissipation module 1150, may function as the first polarization antenna unit 110A involved in one polarization of the radiating element 120 configured to radiate a dual-polarized beam. The other-side PA board 140-2 and the other-side RF filter 130-2, which are stacked and disposed on the other surface of the single heat dissipation module 1150, may function as the second polarization antenna unit 110B involved in the other polarization of the radiating element 120 configured to radiate the dual-polarized beam.

The antenna unit 1110 according to another embodiment of the present disclosure differs from the antenna unit 110 according to the above-described embodiment of the present disclosure, which includes two heat dissipation portions, namely, the first and second heat dissipation portions 150-1 and 150-2 corresponding to heat dissipation modules 150 for respective polarizations. In the antenna unit 1110, heat generated from the heat-generating elements 145 mounted on the one-side PA board 140-1 of the first polarization antenna unit 110A and the heat-generating elements 145 mounted on the other-side PA board 140-2 of the second polarization antenna unit 110B, which are stacked and disposed on opposite surfaces of the single heat dissipation module 1150, is dissipated simultaneously through a single heat dissipation path.

Here, bonding force for the heat-generating elements 145 on the one-side PA board 140-1 and the other-side PA board 140-2 with respect to one surface and the other surface of the single heat dissipation module 1150 may be provided through coupling force between the one-side RF filter 130-1 and the other-side RF filter 130-2 described above.

More specifically, as shown in FIGS. 15 and 16, the one-side RF filter 130-1 and the other-side RF filter 130-2 may be formed such that a length in a front-rear width direction is greater than a front-rear width length of the inner heat dissipation portion 1151 of the heat dissipation module 1150.

Here, at front and rear ends of the one-side RF filter 130-1 and at front and rear ends of the other-side RF filter 130-2, there may be formed front coupling flanges 131F-a and 131F-b protruding further forward than a front end of the inner heat dissipation portion 1151 and rear coupling flanges 131R-a and 131R-b protruding further rearward than a rear end of the inner heat dissipation portion 1151.

As shown in FIG. 16, screw fastening holes 132 may be formed in the front coupling flanges 131F-a and 131F-b and the rear coupling flanges 131R-a and 131R-b in the form of through-holes or threaded holes for mutually fastening the one-side RF filter 130-1 and the other-side RF filter 130-2 by fixing screws 133.

According to the antenna unit 1110 according to another embodiment of the present disclosure having the above configuration, at least one surface and the other surface corresponding to the inner heat dissipation portion 1151 of the single heat dissipation module 1150 may be firmly supported from the outside through the one-side PA board 140-1 and the other-side PA board 140-2, which are supported by the one-side RF filter 130-1 and the other-side RF filter 130-2.

Thus, despite internal pressure variations generated during phase change of the refrigerant in a refrigerant flow space 1158 provided inside the inner heat dissipation portion 1151, rigidity of the one surface and the other surface formed by the metal panel members may be additionally reinforced.

In addition, by fastening with the fixing screws 133 described above, surface thermal contact between the heat-generating elements 145 of the one-side PA board 140-1 and the other-side PA board 140-2 may be more stably realized through the fastening force.

Further, the single heat dissipation module 1150 may effectively dissipate heat generated from the heat-generating elements 145 of both the first polarization antenna unit 110A and the second polarization antenna unit 110B involved in dual polarization, and, compared to the antenna unit 110 according to one embodiment of the present disclosure, the number of heat dissipation modules 1150 may be reduced, thereby providing an advantage of lowering manufacturing costs of the product.

According to the RF module 100 for the antenna and the antenna device 1 including the same according to one embodiment of the present disclosure configured as described above, beam forming of the radiating element 120, which constitutes one polarization unit implemented with 128 TRx RF channels, may be individually controlled. In addition, even without adding supplementary configurations such as sub-arrays, a narrow design of the radiated beam may be achieved in a very simple manner. Furthermore, by employing the heat dissipation module 150 having an improved heat dissipation structure to efficiently release system heat concentrated from heat-generating elements that are conventionally intensively mounted on a single planar board (such as a main board), it is possible to implement Massive MIMO for 5G-Advanced to 6G next-generation communication.

However, even in the RF module 100 for the antenna and the antenna device 1 including the same according to one embodiment of the present disclosure, when the plurality of antenna units 110 are arranged in a stack-up stacking and tile-type stacking configuration, a narrow beam design may still be difficult depending on the density between radiating elements 120. In this case, interference between beams radiated through adjacent RF channels may be minimized by increasing the spacing between the radiating elements 120 slightly beyond the ideal spacing of 0.5λ (e.g., to 0.75λ).

More specifically, the spacing distance between radiating elements having the same polarization characteristics is generally 0.5λ (where λ denotes a wavelength at a center frequency of a frequency band of the antenna array). In order to ensure weak correlation, a larger spacing distance is preferable, and the spacing distance between adjacent rows (see 101 to 108) of radiating elements 120 may be adjusted within a range of 0.5λ to 1.0λ.

In addition, on the premise that the above-described heat dissipation issues caused by the exponential increase in RF chains may be effectively resolved through the heat dissipation module 150, another possible solution, at least theoretically, is to increase the number of radiating elements 120 in the vertical direction and further reduce the angle of the radiated beam, thereby forming a pencil beam.

In this case, according to the antenna RF module 100 and the antenna device 1 including the same according to one embodiment of the present disclosure, although eight radiating elements 120 are illustrated as being arranged in the vertical direction to implement RF channels based on 128TRx, it will be readily understood that, if eight additional radiating elements 120 are further arranged in the vertical direction, a total of sixteen radiating elements may be provided to implement RF channels based on 256TRx. Furthermore, if the number of radiating elements 120 arranged in the vertical direction is doubled to thirty-two, a total of thirty-two radiating elements 120 may be provided to implement RF channels based on 512TRx.

FIG. 17 is a partially cutaway perspective view and a partially enlarged perspective view from another angle, illustrating a lighting device 1a including the heat dissipation module 150 according to one embodiment of the present disclosure.

As shown in FIG. 17, the lighting device 1a including the heat dissipation module 150 according to one embodiment of the present disclosure may include a box-shaped lighting body 10 having one side opened for light irradiation and having an installation space (not shown) formed therein, an LED board 140a disposed in the installation space of the lighting body 10 and having LED elements mounted on at least one of its two surfaces, and an LED module 110a electrically signal-connected to the LED board 140a and vertically arranged in the installation space in an up-and-down direction.

Here, the LED module 110a may include the heat dissipation module 150 coupled to one surface or the other surface of the LED board 140a in a vertical or horizontal direction so as to dissipate heat generated from heat-generating surfaces of the LED elements 145a (heat-generating elements) mounted on the LED board 140a.

In this case as well, the heat dissipation module 150, as described above, may include an inner heat dissipation portion 151 that extends into the installation space to receive and conduct heat from the LED elements 145a (heat-generating elements), and an outer heat dissipation portion 152 that extends to the outside of the installation space to exchange heat transferred from the inner heat dissipation portion 151 with air (outside air) in the outer space.

In addition, the refrigerant flow space 158 may include a first section, which is an evaporation region that receives heat from the LED elements 145a to be cooled, and a second section, which is a path through which liquid refrigerant, condensed from a vapor phase to a liquid phase, flows back to the first section by surface tension or gravity.

In this case, it will be understood that the inner heat dissipation portion 151 is defined as including the above-described first section and at least a portion of the second section, whereas the outer heat dissipation portion 152 is defined as including only the second section.

In particular, in the lighting device 1a including the heat dissipation module 150 according to one embodiment of the present disclosure, the inner heat dissipation portion 151 corresponding to a coupling end may be coupled in a fitting manner using a coupling intermediary structure such as a support housing body 170.

Here, the support housing body 170 may be formed with a substantially "U"-shaped cross-sectional groove. When the LED board 140a is inserted and stacked into the cross-sectional groove, the coupling end corresponding to the first section of the heat conduction panel body is fitted between a pair of installation brackets 190 that mediate fixation with respect to the cross-sectional groove portion, thereby achieving coupling by a fitting operation.

According to the heat dissipation module 150, the heat dissipation device, the RF module 100 for the antenna, the antenna device 1, and the lighting device 1a including the same according to one embodiment of the present disclosure configured as described above, even when the functional elements are arranged to extend in the vertical direction and are distributed within the internal space (installation space 10S) of the housing body (antenna housing body 10), design flexibility in arranging the respective functional elements may be secured through the heat dissipation module 150 including a heat conduction panel body divided such that the first section and the second section are clearly distinguished in their respective functions. Moreover, by maximizing heat dissipation performance, an advantage is provided in that the system performance of the electronic apparatus (electronic device) may be enhanced to the greatest extent.

As described above, the heat dissipation module and the heat dissipation device, the RF module for the antenna, the antenna device, and the lighting device including the same according to one embodiment of the present disclosure have been described in detail with reference to the accompanying drawings. However, embodiments of the present disclosure are not necessarily limited to the above-described embodiments, and it will be apparent that various modifications and equivalent implementations are possible by those skilled in the art. Therefore, the true scope of the present disclosure is defined by the claims set forth below.

### [Industrial Applicability]

The present disclosure provides a heat dissipation module and a heat dissipation device, an RF module for an antenna, an antenna device, and a lighting device including the same, which can rapidly discharge system operating heat to the outside from an installation space, thereby further improving the performance of the device, when a distributed layout design of heat-generating elements within the limited installation space is required due to electrical operation.

## Claims

1. A heat dissipation module comprising:
a heat conduction panel body having a refrigerant flow space that is a sealed space in which a refrigerant is accommodated and circulates between liquid and vapor phases while undergoing a phase change to transfer heat,
wherein the refrigerant flow space comprises:
a first section serving as an evaporation region that receives heat from a heat-generating element to be cooled; and
a second section serving as a path through which a liquid refrigerant, condensed from a vapor phase of the refrigerant, flows to the first section by surface tension or gravity, and
wherein the heat-generating element is coupled to an outer side of the heat conduction panel body corresponding to the first section by either a fitting method or a bonding method.

2. The heat dissipation module of claim 1, wherein the first section of the refrigerant flow space is disposed within an inner space in which the heat-generating elements are arranged, and at least a portion of the second section of the refrigerant flow space is disposed so as to be exposed to an outer space physically partitioned from the inner space.

3. The heat dissipation module of claim 2, wherein, when the inner space and the outer space are physically partitioned by a housing body,
the first section of the refrigerant flow space is positioned relatively lower with respect to a direction of gravity and is disposed in an internal space of the housing body, and
the second section of the refrigerant flow space is positioned relatively higher with respect to the direction of gravity and is disposed so as to be exposed to the outer space outside the housing body.

4. The heat dissipation module of claim 3, wherein the refrigerant flow space is formed such that the first section and the second section communicate with each other so that, as the refrigerant undergoes the phase change, the refrigerant circulates between vapor and liquid phases and flows from a lower end of the first section to an upper end of the second section.

5. The heat dissipation module of any one of claims 1 to 4, wherein, when a portion of the heat conduction panel body corresponding to the first section is defined as an inner heat dissipation portion,
the inner heat dissipation portion is provided as either a heat pipe or a first phase-change fin, in which a refrigerant is accommodated therein and the accommodated refrigerant undergoes a phase change to circulate between vapor and liquid phases.

6. The heat dissipation module of claim 5, wherein the first phase-change fin has one surface made of SUS and the other surface made of Cu.

7. The heat dissipation module of any one of claims 1 to 4, wherein, when a portion of the heat conduction panel body corresponding to the second section is defined as an outer heat dissipation portion,
the outer heat dissipation portion is configured as a second phase-change fin that communicates with the first section and in which the refrigerant, phase-changed into a vapor phase refrigerant from the first section, is heatexchanged with outside air and condensed into a liquid phase refrigerant.

8. The heat dissipation module of claim 7, wherein the second phase-change fin has one surface made of SUS and the other surface made of Cu.

9. A heat dissipation device comprising:
a functional element that is electrically driven and performs a predetermined function;
a plurality of device modules configured to control the functional element on a module-by-module basis; and
a heat dissipation module coupled to the device modules in a vertical or horizontal direction so as to dissipate heat generated from heat-generating surfaces of heat-generating elements provided in the device modules for respective functions,
wherein the heat dissipation module comprises a heat conduction panel body having a refrigerant flow space that is a sealed space in which a refrigerant is accommodated and circulates between liquid and vapor phases while undergoing a phase change to transfer heat,
wherein the refrigerant flow space comprises: a first section serving as an evaporation region that receives heat from a heat-generating element to be cooled; and a second section serving as a path through which a liquid refrigerant, condensed from a vapor phase of the refrigerant, flows to the first section by surface tension or gravity, and
wherein the heat-generating element is coupled to an outer side of the heat conduction panel body corresponding to the first section by either a fitting method or a bonding method.

10. The heat dissipation device of claim 9, wherein the first section of the refrigerant flow space is disposed within an inner space in which the heat-generating elements are arranged, and at least a portion of the second section of the refrigerant flow space is exposed to an outer space that is physically partitioned from the inner space.

11. The heat dissipation device of claim 10, wherein, when the inner space and the outer space are physically partitioned by a housing body,
the first section of the refrigerant flow space is positioned relatively lower with respect to a direction of gravity and is disposed in an internal space of the housing body, and
the second section of the refrigerant flow space is positioned relatively higher with respect to the direction of gravity and is disposed so as to be exposed to the outer space outside the housing body.

12. The heat dissipation device of claim 11, wherein the refrigerant flow space is formed such that the first section and the second section communicate with each other so that, as the refrigerant undergoes the phase change, the refrigerant circulates between vapor and liquid phases and flows from a lower end of the first section to an upper end of the second section.

13. The heat dissipation device of any one of claims 9 to 12, wherein, when a portion of the heat conduction panel body corresponding to the first section is defined as an inner heat dissipation portion,
the inner heat dissipation portion is provided as either a heat pipe or a first phase-change fin, in which a refrigerant is accommodated therein and the accommodated refrigerant undergoes a phase change to circulate between vapor and liquid phases.

14. The heat dissipation device of claim 13, wherein the first phase-change fin has one surface made of SUS and the other surface made of Cu.

15. The heat dissipation device of any one of claims 9 to 12, wherein, when a portion of the heat conduction panel body corresponding to the second section is defined as an outer heat dissipation portion,
the outer heat dissipation portion is configured as a second phase-change fin that communicates with the first section and in which the refrigerant, phase-changed into a vapor phase refrigerant from the first section, is heatexchanged with outside air and condensed into a liquid phase refrigerant.

16. The heat dissipation device of claim 15, wherein the second phase-change fin has one surface made of SUS and the other surface made of Cu.

17. An RF module for an antenna, comprising:
a radiating element having at least one polarization;
a plurality of antenna units each including an **RF** chain corresponding to each polarization of the radiating element so as to individually control the polarization of the radiating element; and
a heat dissipation module coupled to the antenna units in a vertical or horizontal direction so as to dissipate heat generated from heat-generating surfaces of heat-generating elements provided in polarization-specific antenna units among the plurality of adjacent antenna units,
wherein the heat dissipation module comprises a heat conduction panel body having a refrigerant flow space that is a sealed space in which a refrigerant is accommodated and circulates between liquid and vapor phases while undergoing a phase change to transfer heat,
wherein the refrigerant flow space comprises: a first section serving as an evaporation region that receives heat from the heat-generating element to be cooled; and a second section serving as a path through which a liquid refrigerant, condensed from a vapor phase of the refrigerant, flows to the first section by surface tension or gravity, and
wherein the heat-generating element is coupled to an outer side of the heat conduction panel body corresponding to the first section by either a fitting method or a bonding method.

18. An RF module for an antenna, comprising:
a radiating element having a plurality of polarizations;
a plurality of antenna units stacked with one another, each antenna unit including an RF chain corresponding to each polarization of the radiating element; and
a heat dissipation module configured to dissipate heat generated from a plurality of heat-generating elements that are vertically arranged such that heat-generating surfaces thereof face left and right, respectively, on one side of a plurality of **RF** filters involved in one polarization among the plurality of adjacent antenna units,
wherein the heat dissipation module comprises a heat conduction panel body having a refrigerant flow space that is a sealed space in which a refrigerant is accommodated and circulates between liquid and vapor phases while undergoing a phase change to transfer heat,
wherein the refrigerant flow space comprises: a first section serving as an evaporation region that receives heat from the heat-generating element to be cooled; and a second section serving as a path through which a liquid refrigerant, condensed from a vapor phase of the refrigerant, flows to the first section by surface tension or gravity, and
wherein the heat-generating element is coupled to an outer side of the heat conduction panel body corresponding to the first section by either a fitting method or a bonding method.

19. The RF module of claim 17 or 18, wherein each of the plurality of antenna units comprises:
a first polarization antenna unit involved in one polarization of the radiating element that is configured to radiate a dual-polarized beam; and
a second polarization antenna unit involved in the other polarization of the radiating element that is configured to radiate the dual-polarized beam.

20. The RF module of claim 19,
wherein the first polarization antenna unit comprises a plurality of one-side RF filters arranged in a stack-up configuration in a single row in an up-down direction and stacked in a tile-type structure vertically such that opposite ends in a longitudinal direction are positioned at front and rear, respectively,
wherein the second polarization antenna unit comprises a plurality of other-side RF filters arranged in a stack-up configuration in a single row in the up-down direction to be stacked in a left-right direction with respect to one of left and right sides of the plurality of one-side RF filters and stacked in a tile-type structure vertically such that opposite ends in a longitudinal direction are positioned at front and rear, respectively, and
wherein filters stacked in the tile-type structure at the same vertical position among the plurality of one-side RF filters and the plurality of other-side RF filters constitute two RF channels.

21. The RF module of claim 20,
wherein each of the plurality of antenna units further comprises:
a one-side feeder line and an other-side feeder line configured to feed predetermined electrical signals to the plurality of one-side RF filters and the plurality of other-side RF filters that constitute the two RF channels; and
a PA board on which heat-generating elements involved in any one of the two RF channels are mounted on one of opposite surfaces thereof,
wherein the PA board is stacked and disposed in the tile-type structure on any one of left and right sides of the plurality of one-side RF filters and the plurality of other-side RF filters.

22. The RF module of claim 21, wherein the plurality of heat-generating elements mounted on the PA board comprise at least one of a Power Amplifier (PA), a Low Noise Amplifier (LNA), and an RFIC.

23. The RF module of claim 21, wherein the heat dissipation module is stacked and disposed in surface thermal contact with an outer surface of the PA board of each of the first polarization antenna unit and the second polarization antenna unit, and receives and dissipates heat generated from the plurality of heat-generating elements.

24. The RF module of claim 23, wherein the heat dissipation module comprises:
an inner heat dissipation portion in surface thermal contact with one side of the PA board on which the plurality of heat-generating elements are mounted; and
an outer heat dissipation portion configured to dissipate heat transferred from the inner heat dissipation portion through heat exchange with outside air.

25. The RF module of claim 24, wherein the inner heat dissipation portion and the outer heat dissipation portion are formed to communicate with each other such that a refrigerant is accommodated therein and the accommodated refrigerant circulates between vapor and liquid phases.

26. The RF module of claim 24, wherein the inner heat dissipation portion is provided as either a plurality of heat pipes or a first phase-change fin of a panel-type heat exchanger, in which a refrigerant is accommodated therein and the accommodated refrigerant undergoes a phase change to circulate between vapor and liquid phases.

27. The RF module of claim 24, wherein the inner heat dissipation portion and the outer heat dissipation portion are provided as a second phase-change fin of a panel-type heat exchanger, which is formed so that a refrigerant is accommodated therein and the inner and outer heat dissipation portions communicate with each other to allow the accommodated refrigerant to circulate between vapor and liquid phases from the inner heat dissipation portion to the outer heat dissipation portion.

28. The RF module of claim 26, wherein the inner heat dissipation portion provided as the first phase-change fin of the panel-type heat exchanger has one surface made of Cu, the one surface being in surface thermal contact with one side of the PA board, and the other surface made of SUS, the other surface not being in surface thermal contact with the one side of the PA board.

29. The RF module of claim 27, wherein the outer heat dissipation portion and the inner heat dissipation portion, each provided as the second phase-change fin of the panel-type heat exchanger, have opposite surfaces made of SUS.

30. The RF module of claim 27,
wherein the outer heat dissipation portion provided as the second phase-change fin of the panel-type heat exchanger has opposite surfaces made of SUS, and
wherein the inner heat dissipation portion provided as the second phase-change fin of the panel-type heat exchanger has one surface made of Cu, the one surface being in surface thermal contact with one side of the PA board, and the other surface made of SUS, the other surface not being in surface thermal contact with the one side of the PA board.

31. The RF module of claim 25,
wherein the inner heat dissipation portion and the outer heat dissipation portion are manufactured such that a refrigerant flow space, in which the refrigerant is accommodated, is formed by joining edges of two metal panel members manufactured by a press forming process, and
wherein the two metal panel members are provided with a plurality of strength reinforcement portions formed by the press forming process to reinforce rigidity thereof and to be mutually joined at least within the refrigerant flow space.

32. The RF module of claim 31, wherein, when the two metal panel members are made of Cu or SUS, the refrigerant is water.

33. The RF module of claim 21,
wherein the radiating element comprises:
a first polarization element connected to a signal transmitted along the one-side feeder line and arranged to be connected to the plurality of one-side RF filters; and
a second polarization element connected to a signal transmitted along the other-side feeder line and arranged to be connected to the plurality of other-side RF filters,
wherein the first polarization element and the second polarization element are seated on front ends of the plurality of one-side RF filters and the plurality of other-side RF filters while one end and the other end thereof cross each other.

34. The RF module of claim 21, wherein front end surfaces of the plurality of one-side RF filters and the plurality of other-side RF filters perform a function of a reflector that reflects a beam radiated from the radiating element forward.

35. The RF module of claim 33,
wherein the radiating element further comprises:
a base panel disposed to partition between the plurality of one-side RF filters and the plurality of other-side RF filters and the first polarization element and the second polarization element, the base panel supporting the first polarization element and the second polarization element,
wherein the base panel has a forward protruding height configured to block radiation of a radiated beam from the first polarization element and the second polarization element toward an adjacent radiating element.

36. The RF module of claim 19, wherein the base panel is supported forward by the PA board.

37. An RF module for an antenna, comprising:
a radiating element having dual polarization;
a first polarization antenna unit and a second polarization antenna unit each including an RF chain corresponding to each polarization of the radiating element so as to individually control the dual polarizations of the radiating element; and
a heat dissipation module configured to dissipate heat generated from heat-generating surfaces of respective heat-generating elements provided in the first polarization antenna unit and the second polarization antenna unit,
wherein the heat dissipation module is a panel-type heat exchanger, and heat-generating elements of the first polarization antenna unit and the second polarization antenna unit are disposed in surface thermal contact with one side and the other side thereof, respectively.

38. The RF module of claim 37,
wherein the first polarization antenna unit comprises a plurality of one-side RF filters arranged in a stack-up configuration in a single row in an up-down direction and stacked in a tile-type structure vertically such that opposite ends in a longitudinal direction are positioned at front and rear, respectively,
wherein the second polarization antenna unit comprises a plurality of other-side RF filters arranged in a stack-up configuration in a single row in the up-down direction to be stacked in a left-right direction with respect to one of left and right sides of the plurality of one-side RF filters and stacked in a tile-type structure vertically such that opposite ends in a longitudinal direction are positioned at front and rear, respectively, and
wherein filters stacked in the tile-type structure at the same vertical position among the plurality of one-side RF filters and the plurality of other-side RF filters constitute two RF channels.

39. The RF module of claim 38,
wherein each of the plurality of antenna units further comprises:
a one-side feeder line and an other-side feeder line configured to feed predetermined electrical signals to the plurality of one-side RF filters and the plurality of other-side RF filters that constitute the two RF channels; and
a PA board on which heat-generating elements involved in any one of the two RF channels are mounted on one of opposite surfaces thereof,
wherein the PA board is stacked and disposed in the tile-type structure on any one of left and right sides of the plurality of one-side RF filters and the plurality of other-side RF filters.

40. The RF module of claim 39, wherein the single heat dissipation module comprises:
an inner heat dissipation portion in surface thermal contact with one side of the PA board on which the plurality of heat-generating elements are mounted; and
an outer heat dissipation portion configured to dissipate heat transferred from the inner heat dissipation portion through heat exchange with outside air.

41. The RF module of claim 40,
wherein the one-side RF filter and the other-side RF filter are formed such that a front-rear width thereof is greater than a front-rear width of the inner heat dissipation portion of the heat dissipation module, and
wherein the first polarization antenna unit and the second polarization antenna unit are coupled to one side and the other side of the single heat dissipation module, respectively, with the PA board involved in the two RF channels interposed therebetween, by fixing screws fastened through front coupling flanges and rear coupling flanges formed at front ends and rear ends of the one-side RF filter and the other-side RF filter.

42. An antenna device comprising:
an antenna housing body having a box shape with a front surface open and an installation space formed therein;
a digital board stacked and coupled within the installation space such that a rear surface thereof is in close contact therewith, and having heat-generating elements mounted and disposed on at least one of opposite surfaces thereof; and
an RF module for an antenna electrically signal-connected to the digital board, the RF module being vertically disposed in an up-down direction such that opposite surfaces thereof face left and right within the installation space,
wherein the RF module for the antenna comprises:
a radiating element having at least one polarization;
a plurality of antenna units each including an RF chain corresponding to each polarization of the radiating element so as to individually control the polarization of the radiating element; and
a heat dissipation module coupled to the antenna units in a vertical or horizontal direction so as to dissipate heat generated from heat-generating surfaces of heat-generating elements provided in polarization-specific antenna units among the plurality of adjacent antenna units, and
wherein the heat dissipation module comprises:
an inner heat dissipation portion extending into the installation space to receive and conduct heat from the heat-generating elements; and
an outer heat dissipation portion extending to an outside of the installation space to exchange heat transferred from the inner heat dissipation portion with air (outside air) in an outer space.

43. The antenna device of claim 42, wherein each of the plurality of antenna units comprises:
a first polarization antenna unit involved in one polarization of the radiating element that is configured to radiate a dual-polarized beam; and
a second polarization antenna unit involved in the other polarization of the radiating element that is configured to radiate the dual-polarized beam.

44. The antenna device of claim 43,
wherein the first polarization antenna unit comprises a plurality of one-side RF filters arranged in a stack-up configuration in a single row in an up-down direction and stacked in a tile-type structure vertically such that opposite ends in a longitudinal direction are positioned at front and rear, respectively,
wherein the second polarization antenna unit comprises a plurality of other-side RF filters arranged in a stack-up configuration in a single row in the up-down direction to be stacked in a left-right direction with respect to one of left and right sides of the plurality of one-side RF filters and stacked in a tile-type structure vertically such that opposite ends in a longitudinal direction are positioned at front and rear, respectively, and
wherein filters stacked in the tile-type structure at the same vertical position among the plurality of one-side RF filters and the plurality of other-side RF filters constitute two RF channels.

45. The antenna device of claim 44,
wherein each of the plurality of antenna units further comprises:
a one-side feeder line and an other-side feeder line configured to feed predetermined electrical signals to the plurality of one-side RF filters and the plurality of other-side RF filters that constitute the two RF channels; and
a PA board on which heat-generating elements involved in any one of the two RF channels are mounted on one of opposite surfaces thereof,
wherein the PA board is stacked and disposed in the tile-type structure on any one of left and right sides of the plurality of one-side RF filters and the plurality of other-side RF filters, and
wherein the inner heat dissipation portion of the heat dissipation module is stacked and arranged in the tile-type structure so as to be in surface thermal contact with an outer surface of the PA board.

46. The antenna device of claim 45,
wherein a male socket portion for electrically coupling to the digital board by socket-pin engagement is provided at a rear end of the PA board among opposite front and rear ends in a width direction thereof, and
wherein the digital board is provided with a female socket portion to which the male socket portion of the PA board is coupled by the socket-pin engagement.

47. The antenna device of claim 46,
wherein the outer heat dissipation portion of the heat dissipation module is exposed to the outer space through an upper end of the antenna housing body, and
wherein a guide slot is formed at the upper end of the antenna housing body to extend in a front-rear direction so as to guide insertion coupling when the PA board is coupled to the digital board by the socket-pin engagement.

48. The antenna device of claim 43,
wherein the outer heat dissipation portion of the heat dissipation module is exposed to the outer space through an upper end of the antenna housing body; and
wherein the antenna device further comprises a finger guard panel assembly coupled to the antenna housing body so as to surround the outer heat dissipation portion exposed to the outer space through the upper end of the antenna housing body without contacting the outer heat dissipation portion.

49. The antenna device of claim 48,
wherein the finger guard panel assembly is configured to shield all portions of the outer heat dissipation portion exposed through the upper end of the antenna housing body except for a front portion thereof; and
wherein the antenna device further comprises a radome panel configured to shield an opened front surface of the antenna housing body and formed of a material through which a beam radiated from the radiating element is transmitted,
wherein a radome extension panel is integrally formed at an upper portion of the radome panel to shield the front portion of the outer heat dissipation portion that is not shielded by the finger guard panel assembly.

50. The antenna device of claim 49, wherein a plurality of vent holes through which air of the outer space passes are formed in at least a portion of the finger guard panel assembly and in the radome extension panel.

51. An antenna device comprising:
an antenna housing body having a box shape with a front surface open and an installation space formed therein;
a digital board stacked and coupled within the installation space such that a rear surface thereof is in close contact therewith, and having heat-generating elements mounted and disposed on at least one of opposite surfaces thereof; and
an RF module for an antenna electrically signal-connected to the digital board, the RF module being vertically disposed in an up-down direction such that opposite surfaces thereof face left and right within the installation space,
wherein the RF module for the antenna comprises:
a radiating element having dual polarization;
a first polarization antenna unit and a second polarization antenna unit each including an RF chain corresponding to each polarization of the radiating element so as to individually control the dual polarizations of the radiating element; and
a heat dissipation module configured to dissipate heat generated from heat-generating surfaces of respective heat-generating elements provided in the first polarization antenna unit and the second polarization antenna unit, and
wherein the heat dissipation module is a panel-type heat exchanger, and heat-generating elements of the first polarization antenna unit and the second polarization antenna unit are disposed in surface thermal contact with one side and the other side thereof, respectively.

52. A lighting device comprising:
a lighting body having a box shape with one surface open for light irradiation and an installation space formed therein;
an LED board disposed in the installation space of the lighting body and having LED elements mounted on at least one of opposite surfaces thereof; and
an LED module electrically signal-connected to the LED board and vertically disposed in an up-down direction within the installation space,
wherein the LED module comprises a heat dissipation module coupled to one surface or the other surface of the LED board in a vertical or horizontal direction so as to dissipate heat generated from heat-generating surfaces of the LED elements mounted on the LED board,
wherein the heat dissipation module comprises:
an inner heat dissipation portion extending into the installation space to receive and conduct heat from the LED elements; and
an outer heat dissipation portion extending to the outside of the installation space to exchange heat transferred from the inner heat dissipation portion with air (outside air) in an outer space.
